# EUROPEAN PATENT APPLICATION

(11) **EP 4 679 963 A1**
(43) Date of publication of application: **14.01.2026**
(21) Application number: 24785163.7
(22) Date of filing: 02.04.2024
(51) Int. Cl.: H05K 9/00, H05K 7/20, H04M 1/02

(54) **ELECTRONIC DEVICE HAVING SHIELDING AND HEAT DISSIPATION STRUCTURE**

(30) Priority: 06.04.2023 KR 20230045653; 23.05.2023 KR 20230066431
(71) Applicant: Samsung Electronics Co., Ltd., Suwon-si, Gyeonggi-do 16677 (KR)
(72) Inventor: JUNG, Chunghyo, Suwon-si Gyeonggi-do 16677 (KR); LIM, Jaedeok, Suwon-si Gyeonggi-do 16677 (KR); KIM, Dohoon, Suwon-si Gyeonggi-do 16677 (KR); PARK, Hyein, Suwon-si Gyeonggi-do 16677 (KR); YUN, Hajoong, Suwon-si Gyeonggi-do 16677 (KR); CHUNG, Haein, Suwon-si Gyeonggi-do 16677 (KR); CHO, Gyuyeong, Suwon-si Gyeonggi-do 16677 (KR)
(74) Representative: Gulde & Partner
(86) International application number: PCT/KR2024/004239
(87) International publication number: WO 2024/210458

(57) **Abstract**

Disclosed is an electronic device. The electronic device includes: a shield can including a first cavity and a first opening to communicate with the first cavity; an electronic component disposed in the first cavity; a shielding sheet disposed at an upper portion of the shield can, communicating with the first cavity , and defining a second cavity, the shielding sheet including a first part contacting the shield can; a heat-dissipation member disposed on the shielding sheet to close the second cavity; and a thermal interface material (TIM) disposed between the heat-dissipation member and the electronic component. The shield can, the shielding sheet, and the heat-dissipation member are electrically connected to each other, the electronic component, the TIM, and the heat-dissipation member are thermally connected to each other, the first cavity has a first width, and the second cavity has a second width, greater than the first width.

## Description

### [Technical Field]

Embodiments disclosed in the disclosure relate to an electronic device having a shielding and heat dissipation structure.

### [Background Art]

A portable communication device, such as a smartphone, may include a shield can that protects an electronic component or an electronic circuit from electromagnetic interference (EMI) or radio-frequency interference (RFI). The shield can is generally formed of a conductive material, and may reduce interference caused by electromagnetic fields by enclosing a sensitive electronic component.

Meanwhile, the shield can may have an open cover for heat dissipation of internal components. However, when a cover of the shield can is opened, a shielding effect may be reduced, and thus, the opened cover of the shield can may be closed with a shielding film to balance heat dissipation performance and shielding performance.

However, it should not be construed that the above-described related art or background art is recognized as prior art.

### [Disclosure]

### [Technical Solution]

An electronic device 100 according to an embodiment of the disclosure, a printed circuit board 150, a shield can 250 that is disposed on the printed circuit board 150 to define a first cavity 10, and has a first opening 15 that communicates with the first cavity 10 at an upper portion thereof, an electronic component 230 that is disposed on the printed circuit board 150, and is located in the first cavity 10, a shielding sheet 200 that is disposed at an upper portion of the shield can 250, communicates with the first cavity 10 through the first opening 15 of the shield can 250, and defines a second cavity 20 having an opened upper side, wherein the shielding sheet 200 includes a first part 211 and 221 that contacts the upper portion of the shield can 250, a heat dissipation member 270, 570, 670, 770, 870, 970, 1070, and 1170 that is disposed on the shielding sheet 200 to close the opened upper side of the second cavity 20, a thermal interface material (TIM) 240 that is disposed between the heat dissipation member 270, 570, 670, 770, 870, 970, 1070, and 1170 and the electronic component 230, and an elastic member 260 that is disposed between the first part 211 and 221 of the shielding sheet 200 and the heat dissipation member 270, 570, 670, 770, 870, 970, 1070, and 1170 in the second cavity 20, and provides an elastic force to the first part 211 and 221, the shield can 250, the shielding sheet 200, and the heat dissipation member 270, 570, 670, 770, 870, 970, 1070, and 1170 may be electrically connected to each other, the electronic component 230, the TIM 240, and the heat dissipation member 270, 570, 670, 770, 870, 970, 1070, and 1170 may be thermally connected to each other, the first cavity 10 may have a first width along a direction that is parallel to the printed circuit board 150, the second cavity 20 may have a second width along a direction that is parallel to the printed circuit board 150, and the second width may be greater than the first width.

An electronic device 100 according to an embodiment of the disclosure may include a display 101, a printed circuit board 150, a shielding sheet 200 and a heat dissipation member 1370 that are disposed between the display 101 and the printed circuit board 150, a shield can 250 that is disposed on the printed circuit board 150 and defines a first cavity 10, and a thermal interface material (TIM) 240 that is disposed between the heat dissipation member 1370 and the electronic component 230, and the shield can 250, the shielding sheet 200, and the heat dissipation member 1370 may be electrically connected to each other, and the electronic component 230, the TIM 240, and the heat dissipation member 1370 may be thermally connected to each other.

### [ Description of Drawings]

FIG. 1A is a diagram illustrating an electronic device according to an embodiment.
FIG. 1B is an exploded perspective view of an electronic device according to an embodiment.
FIG. 2 is a view illustrating a shielding and heat dissipation structure of an electronic device according to an embodiment.
FIG. 3A is a view illustrating factors that affect shielding performance of an electronic device according to an embodiment.
FIG. 3B is a graph depicting shielding performance according to a height of a second cavity.
FIG. 3C is a graph depicting shielding performance depending on a width of a second cavity.
FIG. 3D is a graph depicting shielding performance depending on frequency.
FIG. 4 is a view illustrating a shielding and heat dissipation structure of an electronic device according to an embodiment.
FIG. 5 is a view illustrating a shielding and heat dissipation structure of an electronic device according to an embodiment.
FIG. 6 is a view illustrating a shielding and heat dissipation structure of an electronic device according to an embodiment.
FIG. 7A is a view illustrating a shielding and heat dissipation structure of an electronic device according to an embodiment.
FIG. 7B is a view illustrating a shielding and heat dissipation structure of an electronic device according to an embodiment.
FIG. 8 is a view illustrating a shielding and heat dissipation structure of an electronic device according to an embodiment.
FIG. 9 is a view illustrating a shielding and heat dissipation structure of an electronic device according to an embodiment.
FIG. 10 is a view illustrating a shielding and heat dissipation structure of an electronic device according to an embodiment.
FIG. 11 is a view illustrating a shielding and heat dissipation structure of an electronic device according to an embodiment.
FIG. 12 is a view illustrating a shielding and heat dissipation structure of an electronic device according to an embodiment.
FIGS. 13A to 13H are views illustrating a shielding and heat dissipation structure of an electronic device according to an embodiment.
FIG. 14 is a block diagram of an electronic device in a network environment according to various embodiments.
FIG. 15 is a view illustrating a comparative embodiment.

### [ Mode for Invention]

Hereinafter, various embodiments of the disclosure may be described with reference to accompanying drawings. However, this is not intended to limit the disclosure to specific embodiments, and it should be understood to include various modifications, equivalents, and/or alternatives of the embodiments of the disclosure.

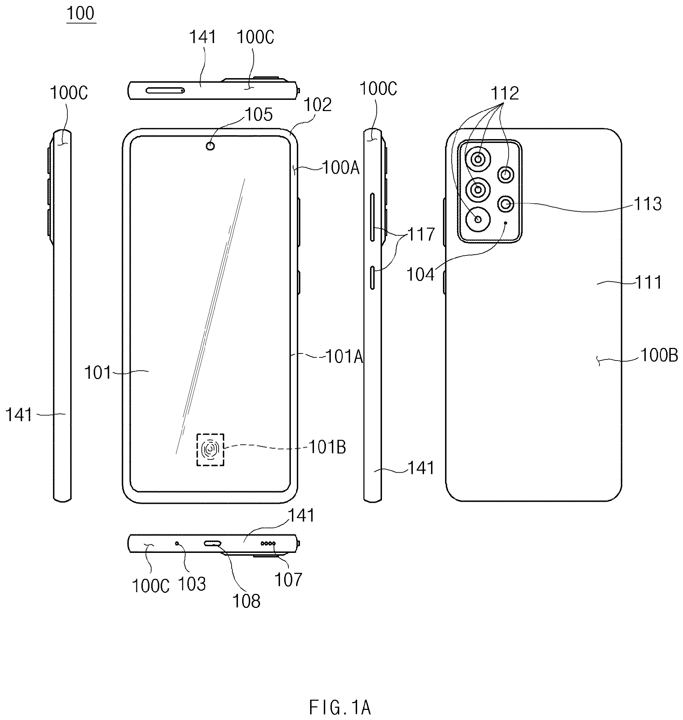

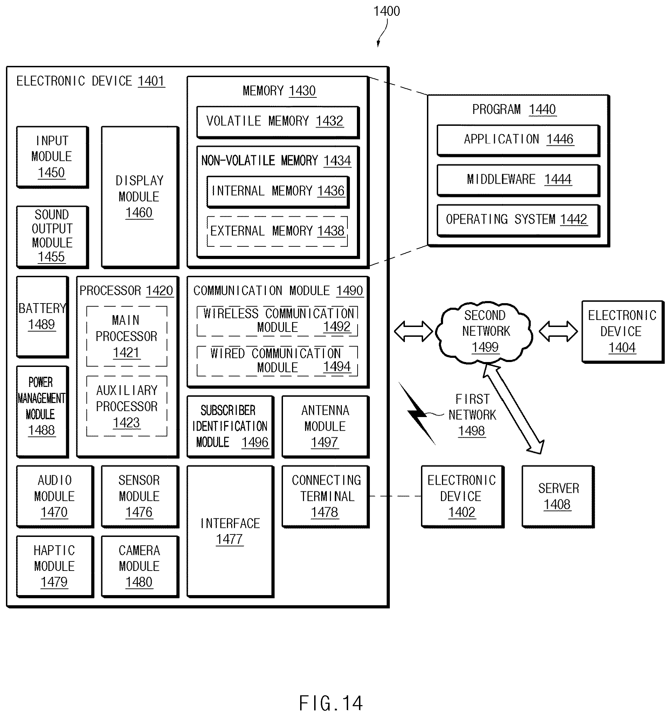

FIG. 1A is a diagram illustrating an electronic device according to an embodiment. Referring to FIG. 1A, an electronic device 100 (e.g., an electronic device 1401 of FIG. 14) according to an embodiment may include a housing. The housing may define an external appearance of the electronic device 100. For example, a housing may define a front surface 100A, a rear surface 100B, and a side surface 100C that encloses a space between the front surface 100A and the rear surface 100B of the electronic device 100. The housing may include a component or a structure that defines at least a portion of the front surface 100A, the rear surface 100B, and/or the side surface 100C. For example, the housing may include at least a portion of a front plate 102, a side member 141, and/or a rear plate 111 that define an external appearance of the electronic device 100.

In an embodiment, the electronic device 100 may include the front plate 102, the rear plate 111, and the side member 141.

The front plate 102 may be formed to be substantially transparent. The front plate 102 may define at least a portion of the front surface 100A of the electronic device 100. In an embodiment, the front plate 102 may include, for example, a glass plate that includes various coating layers, or a polymer plate, but is not limited thereto.

The rear plate 111 may be formed to be substantially opaque. The rear plate 111 may define at least a portion of the rear surface 100B. For example, the rear plate 111 may be implemented with a coated or colored glass, a ceramic, a polymer, a metal (e.g., aluminum, stainless steel (STS), or magnesium), or a combination of at least two of the above-described materials.

The side member 141 may be coupled to the front plate 102 and/or the rear plate 111. The side member 141 may define at least a portion of the side surface 100C of the electronic device 100. For example, the side member 141 may define an entirety of the side surface 100C of the electronic device 100, and in another example, the side member 141 may define the side surface 100C of the electronic device 100 together with the front plate 102 and/or the rear plate 111.

The side member 141 may include a metal and/or a polymer. The rear plate 111 and the side member 141 may be formed integrally, and may include the same material, for example, a metal material, such as aluminum, but are not limited thereto. For example, the rear plate 111 and the side member 141 may be formed as separate components and/or may include different materials.

In an embodiment, the electronic device 100 may include at least one of a display 101, an audio module 103, 104, and 107, a sensor module (not illustrated), a camera module 105, 112, and 113, a key input device 117, a light emitting device (not illustrated), and/or a connector hole 108.

The display 101 (e.g., a display module 1460 of FIG. 14) may be visually exposed through a substantial portion of the front plate 102. For example, the display 101 may be disposed on a rear surface of the front plate 102 to be at least partially visible through the front surface 100A and to output light through the front surface 100A. The display 101 may be coupled to a touch sensing circuit, a pressure sensor that may measure an intensity (or pressure) of a touch, and/or a digitizer that detects a magnetic stylus pen or may be disposed adjacent thereto.

In an embodiment, the display 101 may include a screen display area 101A. The display 101 may provide visual information to a user through the screen display area 101A. In the illustrated embodiment, although it is illustrated that, when the front surface 100A is viewed from a front side, the screen display area 101A is spaced apart from an outer periphery of the front surface 100A and is located inside the front surface 100A, the disclosure is not limited thereto. In another embodiment, when the front surface 100A is viewed from a front side, at least a portion of a periphery of the screen display area 101A may substantially coincide with a periphery of the front surface 100A (or the front plate 102).

In an embodiment, the screen display area 101A may include a sensing area 101B that is configured to acquire biometric information of a user. Here, a meaning that the screen display area 101A includes the sensing area 101B may be understood as at least a portion of the sensing area 101B being able to overlap the screen display area 101A. For example, the sensing area 101B may mean an area, in which visual information may be displayed by the display 101 as in the other areas of the screen display area 101A, and the user's biometric information (e.g., fingerprint) may be additionally acquired. In another embodiment, the sensing area 101B may be formed in the key input device 117.

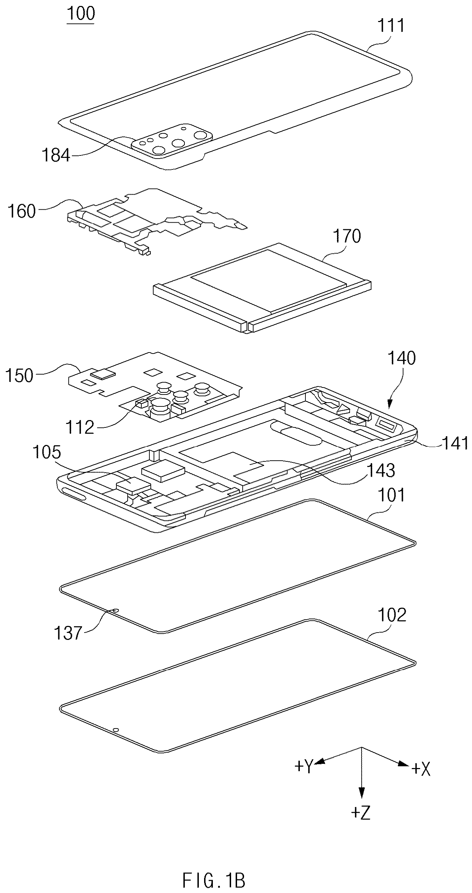

In an embodiment, the display 101 may include an area (e.g., a camera area 137 of FIG. 1B), in which a first camera module 105 (e.g., a camera module 1480 of FIG. 14) is located. In an embodiment, an opening may be formed in the area of the display 101, and a first camera module 105 (e.g., a punch hole camera) may be disposed at least partially in the opening to face the front surface 100A. In this case, the screen display area 101A may enclose at least a portion of a periphery of the opening. In another embodiment, a first camera module 105 (e.g., an under display camera (UDC)) may be disposed under the display 101 to overlap the area of the display 101. In this case, the display 101 may provide visual information to a user through the area, and additionally, the first camera module 105 may acquire an image through the area of the display 101.

In an embodiment, audio modules 103, 104, and 107 (e.g., an audio module 1470 of FIG. 14) may include microphone holes 103 and 104 and a speaker hole 107.

A microphone (not illustrated) for acquiring external sound may be disposed in the microphone holes 103 and 104. The microphone may include a plurality of microphones to sense a direction of sound, but is not limited thereto. The microphone holes 103 and 104 may include a first microphone hole 103 that is formed in a partial of the side surface 100C and a second microphone hole 104 that is formed in a partial area of the rear surface 100B. The second microphone hole 104 may be disposed adjacent to the camera modules 112 and 113. For example, the second microphone hole 104 may acquire sound depending on an operation of the camera modules 112 and 113. However, the present disclosure is not limited thereto, and the second microphone hole 104 may be operated independently of the camera modules 112 and 113.

The speaker hole 107 may include an external speaker hole 107 and a receiver hole (not illustrated) for a call. The external speaker hole 107 may be formed at a portion of the side surface 100C of the electronic device 100. In another embodiment, the external speaker hole 107 may be implemented with one hole with the microphone hole 203. Although not illustrated, a receiver hole for a call (not illustrated) may be formed at an upper end portion of the electronic device 100, for example, with reference to the illustration of FIG. 1A.

In an embodiment, the electronic device 100 may include at least one speaker (not illustrated) (e.g., a sound output module 1455 of FIG. 14) that is configured to output sound to the outside through the external speaker hole 107 and/or the receiver hole for a call (not illustrated).

The sensor module (not illustrated) (e.g., the sensor module 1476 of FIG. 14) may generate an electrical signal or a data value that corresponds to an internal operation state of the electronic device 100 or an external environment state. For example, the sensor module may include at least one or more of a proximity sensor, a heart rate monitor (HRM) sensor, a fingerprint sensor, a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illumination sensor.

The camera modules 105, 112, and 113 (e.g., a camera module 1480 of FIG. 14) may include a first camera module 105 that is disposed to face the front surface 100A of the electronic device 100, a second camera module 112 that is disposed to face the rear surface 100B, and a flash 113. Each of the first camera module 105 and the second camera module 112 may include one or more lenses, an image sensor, and/or an image signal processor. The second camera module 112 may include a plurality of cameras. The flash 113 may include, for example, a light emitting diode or a xenon lamp.

The key input device 117 (e.g., an input module 1450 of FIG. 14) may be disposed on the side surface 100C of the electronic device 100 to receive a user input. In another embodiment, the electronic device 100 may not include all or a part of the key input devices 117, and a key input device not included may be implemented on the display 101 in the form of a soft key.

The connector hole 108 may be formed on the side surface 100C of the electronic device 100 to receive a connector of an external device. A connection terminal (e.g., a connection terminal 1478 of FIG. 14) that is electrically connected to a connector of an external device may be disposed inside the connector hole 108. The electronic device 100 according to an embodiment may include an interface module (e.g., an interface 1477 of FIG. 14) for processing electrical signals transmitted and received through the connection terminal.

Hereinafter, repeated descriptions for components having the same reference numerals as the components described above may be omitted.

FIG. 1B is an exploded perspective view of an electronic device according to an embodiment. Referring to FIG. 1B, the electronic device 100 according to an embodiment may include a frame structure 140, a printed circuit board 150, a cover plate 160, and a battery 170.

The frame structure 140 may be disposed between the display 101 and the rear plate 111. The frame structure 140 may include a side member 141 and a support member 143. The side member 141 may enclose a space between the rear plate 111 and the front plate 102 (and/or the display 101). The support member 143 may extend from the side member 141 into the space. The side member 141 and the support member 143 may be formed integrally or may be formed separately. The side member 141 and/or the support member 143 may be formed of a metal and/or a non-metal material (e.g., a resin).

A display 101 may be disposed on one surface (e.g., a surface that faces the +Z direction) of the support member 143. The printed circuit board 150, the battery 170, and the second camera module 112 may be disposed on an opposite surface (e.g., a surface that faces the -Z direction) of the support member 143. The display 101, the printed circuit board 150, the battery 170, and the second camera module 112 may be seated on a recess or a mounting surface defined by the side member 141 and/or the support member 143 of the frame structure 140, respectively.

The printed circuit board 150 may be coupled to the frame structure 140. For example, the printed circuit board 150 may be fixedly disposed on the support member 143 of the frame structure 140 through a fastening member, such as a screw.

The cover plate 160 may be disposed between the printed circuit board 150 and the rear plate 111. In an embodiment, the cover plate 160 may be disposed on the printed circuit board 150. For example, the cover plate 160 may be disposed on a surface of the printed circuit board 150, which faces the -Z direction. The cover plate 160 may cover at least a partial area of the printed circuit board 150. The cover plate 160 may be fixedly disposed on the printed circuit board 150 through a fastening member (e.g., a screw), or may be coupled to the frame structure 140 together with the printed circuit board 150 through the fastening member. The cover plate 160 may protect the printed circuit board 150 or components disposed on the printed circuit board 150 from a physical impact, and may prevent or and/or reduce a connector coupled to the printed circuit board 150 from being separated. The cover plate 160 may include a metal and/or a resin.

A processor (e.g., the processor 1420 of FIG. 14), a memory (e.g., the memory 1430 of FIG. 14), and/or an interface (e.g., the interface 1477 of FIG. 14) may be disposed on the printed circuit board 150. For example, the processor may include one or more of a central processing unit, an application processor, a graphic processing device, an image signal processor, a sensor hub processor, or a communication processor. The memory may include, for example, a volatile memory or a nonvolatile memory. The interface may include, for example, a high definition multimedia interface (HDMI), a universal serial bus (USB) interface, a secure digital (SD) card interface, and/or an audio interface. The interface may electrically or physically connect the electronic device 200 to an external electronic device and may include a USB connector, an SD card/multi-media card (MMC) connector, or an audio connector.

The battery 170 (e.g., the battery 1489 of FIG. 14) may supply power to at least one component of the electronic device 100. For example, the battery 170 may include a secondary battery or a fuel cell. At least a portion of the battery 170 may be disposed on substantially the same plane as the printed circuit board 150, but the disclosure is not limited thereto.

The first camera module 105 (e.g., a front camera) may be disposed at at least a portion of the frame structure 140 (e.g., the support member 143) so that a lens may receive external light through a partial area (e.g., a camera area 137) of the front plate 102 (e.g., the front surface 100A of FIG. 1).

The second camera module 112 (e.g., a rear camera) may be disposed between the frame structure 140 and the rear plate 111. The second camera module 112 may be electrically connected to the printed circuit board 150 through a connection member (e.g., a connector). The second camera module 112 may be disposed such that the lens may receive external light through a camera area 184 of the rear plate 111 of the electronic device 100.

The camera area 184 may be formed on a surface (e.g., the rear surface 100B of FIG. 1) of the rear plate 111. In an embodiment, the camera area 184 may be formed to be at least partially transparent such that external light may be incident on a lens of the second camera module 112. In an embodiment, at least a portion of the camera area 184 may protrude by a specific height from the surface of the rear plate 111. However, the disclosure is not limited thereto, and, in another embodiment, the camera area 184 may define substantially the same plane as the surface of the rear plate 111.

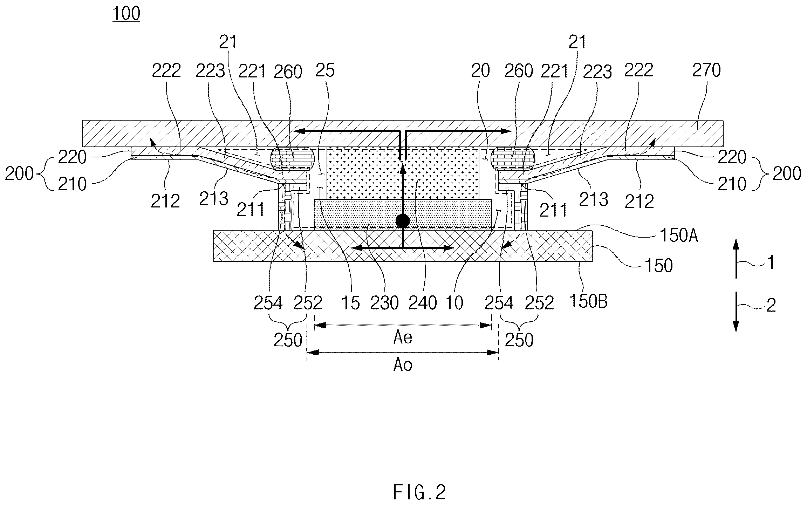

FIG. 2 is a view illustrating a shielding and heat dissipation structure of an electronic device according to an embodiment. Referring to FIG. 2, the electronic device 100 according to an embodiment may include a printed circuit board 150, an electronic component 230, a shield can 250, a shielding sheet 200, an elastic member 260, a heat dissipation member 270, and a thermal interface material (TIM) 240.

The printed circuit board 150 may include a substantially flat rigid printed circuit board. The printed circuit board 150 may include a structure, in which non-conductive layers and conductive layers are alternately stacked. The conductive layer may be formed of a conductive metal (e.g., copper). A portion of the conductive layer may function as an area for grounding.

The printed circuit board 150 may include a first surface 150A and a second surface 150B that faces the first surface 150A. The first surface 150A may face a first direction 1, and the second surface 150B may face a second direction 2. The first direction 1 and the second direction 2 may be directions that are substantially perpendicular to the printed circuit board 150, the first surface 150A, or the second surface 150B. The first direction 1 may be a direction that faces the heat dissipation member 270 from the printed circuit board 150, and the second direction 2 may be a direction that is opposite to the first direction 1.

The electronic component 230 may be disposed on the printed circuit board 150. For example, the electronic component 230 may be mounted on the first surface 150A of the printed circuit board 150. The electronic component 230 may be located in a first cavity 10 to be enclosed by the shield can 250. The electronic component 230 may include, for example, integrated circuits (ICs), IC chips, or semiconductor devices. The electronic component 230 may include, for example, at least one of a processor (e.g., the processor 1420 of FIG. 14), a communication module (e.g., the communication module 1490 of FIG. 14), a memory (e.g., the memory 1430 of FIG. 14), and/or a power management module (e.g., the power management module 1488 of FIG. 14).

The shield can 250 may be disposed on the printed circuit board 150. The shield can 250 may be attached (e.g., soldered) to the first surface 150A of the printed circuit board 150 to enclose the electronic component 230. The shield can 250 may be mounted on the printed circuit board 150 to define a first cavity 10, in which the electronic component 230 is located. For example, the first cavity 10 may be defined by an inner surface of the shield can 250 and the first surface 150A of the printed circuit board 150. A first opening 15 that communicates with the first cavity 10 may be formed at an upper portion of the shield can 250.

The first opening 15 may at least partially overlap the electronic component 230. For example, the first opening 15 may at least partially overlap the electronic component 230 with respect to the first direction 1. A first side (e.g., the first direction 1) of the first cavity 10 may be opened through the first opening 15, and a second side (e.g., the second direction 2) of the first cavity 10 may be closed by the first surface 150A of the printed circuit board 150.

In one embodiment, a size of the first opening 15 may be formed to be equal to or less than a size of the electronic component 230. A transverse length of the first opening 15 is formed to be equal to or less than a transverse length of the electronic component 230, and a longitudinal length of the first opening 15 may be formed to be equal to or less than a longitudinal length of the electronic component 230.

In another embodiment, a size Ao of the first opening 15 may be formed to be greater than a size Ae of the electronic component 230. A transverse length of the first opening 15 is formed to be greater than a transverse length of the electronic component 230, and a longitudinal length of the first opening 15 may be formed to be greater than a longitudinal length of the electronic component 230.

The shield can 250 may be disposed between the shielding sheet 200 and the printed circuit board 150. The shield can 250 may be formed of a conductive material such as a conductive metal or alloy (e.g., stainless steel), and may be electrically connected to ground areas (not illustrated) of the shielding sheet 200 and the printed circuit board 150.

The shield can 250 may include a sidewall 254 and a cover 252 that covers the sidewall 254. The sidewall 254 may extend from the printed circuit board 150. For example, the sidewall 254 may extend in a first direction 1 from the first surface 150A of the printed circuit board 150. The sidewall 254 may extend from the first surface 150A of the printed circuit board 150 to the shielding sheet 200. The sidewall 254 may enclose an entire periphery of the electronic component 230 when the printed circuit board 150 is viewed from above (e.g., when viewed in the second direction 2). A lower end portion (e.g., an end in the second direction 2) of the sidewall 254 may be electrically connected to the ground area of the printed circuit board 150. An upper end portion (e.g., an end in the first direction 1) of the sidewall 254 may be opened.

The cover 252 may be formed in a flat structure without a step or may be formed to include a step. As an example, when the sidewall 254 is formed to be higher than a height of the electronic component 230, the cover 252 may be formed in a flat structure without a step.

The cover 252 may be disposed at an upper end portion of the sidewall 254. The cover 252 may extend from the sidewall 254 to partially close the opened upper end portion of the sidewall 254. For example, the cover 252 may extend to an inside of the sidewall 254, on which the electronic component 230 is located, from the upper end portion of the sidewall 254. For example, the cover 252 may extend from an upper end portion of the sidewall 254 in a direction that faces a center of the first cavity 10. The cover 252 may extend from the upper end portion of the sidewall 254 in a direction that is parallel to the first surface 150A, but is not limited thereto. The first opening 15 may be formed at a center of the cover 252. The cover 252 may define an upper portion of the shield can 250. The upper portion of the shield can 250 may be opened through the first opening 15 formed in the cover 252. The sidewall 254 and the cover 252 may be formed integrally, but are not limited thereto.

The shielding sheet 200 may be disposed at an upper portion (e.g., the first direction 1) of the shield can 250. A second opening 25 that communicates with the first opening 15 may be formed in the shielding sheet 200. The second opening 25 may be defined by the shielding film 210 and the conductive adhesive layer 220 of the shielding sheet 200. The second opening 25 may overlap the first opening 15 and the electronic component 230. For example, the second opening 25 may be at least partially aligned with the first opening 15 and the electronic component 230 with respect to the first direction 1.

The shielding sheet 200 may be disposed between the shield can 250 and the heat dissipation member 270, and may define a second cavity 20 that communicates with the first cavity 10. For example, the second cavity 20 may be defined by an inner surface of the shielding sheet 200 and the heat dissipation member 270. The first cavity 10 and the second cavity 20 may communicate with each other through the first opening 15 and the second opening 25. A first side (e.g., the first direction 1) of the second cavity 20 may be closed by the heat dissipation member 270, and a second side (e.g., the second direction 2) of the second cavity 20 may be opened through the second opening 25.

The second cavity 20 may include a section, a width of which is greater than that of the first cavity 10. For example, a maximum width of the second cavity 20 may be greater than the width of the first cavity 10. The maximum width of the second cavity 20 may be greater than the width of the first cavity 10 that is defined by the sidewall 254. The maximum width of the second cavity 20 may be greater than the maximum width of the first cavity 10. The width of the first cavity 10 or the second cavity 20 may be a length with respect to a direction that is substantially parallel to the printed circuit board 150, the first surface 150A, or the second surface 150B.

The shielding sheet 200 may be disposed between the shield can 250 and the heat dissipation member 270. For example, the shielding sheet 200 may extend from the cover 252 of the shield can 250 to the heat dissipation member 270. The shielding sheet 200 may be formed to be electrically conductive, and may be electrically connected to the shield can 250 and the heat dissipation member 270. The shield can 250 and the heat dissipation member 270 may be electrically connected to each other through the shielding sheet 200.

The shielding sheet 200 may include the shielding film 210, and a conductive adhesive layer 220 that is stacked on the shielding film 210 (e.g., the first direction 1). The conductive adhesive layer 220 may be located between the shielding film 210 and the heat dissipation member 270. The conductive adhesive layer 220 may be located between the shielding film 210 and the elastic member 260.

The shielding film 210 may be formed to have flexibility and electrical conductivity. For example, the shielding film 210 may be formed by repeatedly coating conductive metals, such as nickel and copper, on a nonwoven fabric base sheet, and combining them. The shielding film 210 may not be manufactured by a thermal compression method, because defects, such as voids, may occur inside the base sheet. In another example, the shielding film 210 may include a foil that is formed of a conductive metal, a natural or synthetic resin film, on which a thin film of a conductive metal is coated, a conductive polymer, in which conductive particles are integrated or a polymer structure is chemically modified to have conductivity, or a material including graphene or a carbon-based substance. The shielding film 210 may not include an adhesive material. Furthermore, as another example, the shielding film 210 may include a conductive metal sheet (e.g., a copper sheet, an aluminum sheet).

The conductive adhesive layer 220 may be formed by coupling a conductive filler and an adhesive material. For example, the conductive adhesive layer 220 may be formed by coating the adhesive material on the shielding film 210 and adding a conductive filler (or conductive particles) to the adhesive material. The adhesive material may include a resin material, such as epoxy, silicone, acrylic, and polyurethane, but is not limited thereto. The conductive filler may include a conductive metal, such as silver, copper, and nickel, or a carbon-based material, such as graphite or carbon black, but is not limited thereto.

The shielding film 210 may include a first part 211, a second part 212, and a third part 213. The first part 211 may be disposed at an upper portion of the shield can 250. The first part 211 may be disposed on the cover 252 of the shield can 250 (e.g., in the first direction 1). The first part 211 may directly contact the cover 252 of the shield can 250 to be electrically connected to the shield can 250. The second part 212 may be located on an upper side of the first part 211. For example, with respect to the first direction 1, the second part 212 may be located more distant from the first surface 150A of the printed circuit board 150 than the first part 211. Furthermore, the second part 212 may be located on an outer side of the first part 211. For example, with respect to one direction that is parallel to the first surface 150A of the printed circuit board 150, the second part 212 may be located more distant from the shield can 250 than the first part 211. The third part 213 may extend from the first part 211 to the second part 212 to connect the first part 211 and the second part 212.

The conductive adhesive layer 220 may include a first part 221, a second part 222, and a third part 223. The first part 221 may be disposed on the first part 211 of the shielding film 210 (e.g., in the first direction 1). The first part 221 of the conductive adhesive layer 220 may be interposed between the first part 211 of the shielding film 210 and the elastic member 260. The first part 221 may attach the first part 211 of the shielding film 210 to the elastic member 260. When the elastic member 260 is formed to have conductivity, the first part 211 of the shielding film 210 may be electrically connected to the heat dissipation member 270 through the first part 221 of the conductive adhesive layer 220 and the elastic member 260.

The second part 222 of the conductive adhesive layer 220 may be disposed on the second part 212 of the shielding film 210 (e.g., in the first direction 1). The second part 222 of the conductive adhesive layer 220 may be interposed between the second part 212 of the shielding film 210 and the heat dissipation member 270. The second part 222 may attach the second part 212 of the shielding film 210 to the heat dissipation member 270, and may electrically connect them. Because the first part 221 and the second part 222 of the conductive adhesive layer 220 are respectively stacked on the first part 211 and the second part 212 of the shielding film 210, the description of the relative positions of the first part 211 and the second part 212 of the shielding film 210 may be equally applied to the first part 221 and the second part 222 of the conductive adhesive layer 220. For example, the second part 222 of the conductive adhesive layer 220 may be located on an upper side of the first part 221, and may be located on an outer side thereof.

The third part 223 of the conductive adhesive layer 220 may be disposed on the third part 213 of the shielding film 210 (e.g., in the first direction 1). The third part 223 may extend from the first part 221 to the second part 222 to connect the first part 221 and the second part 222. In another embodiment, the conductive adhesive layer 220 may not include the third part 223. In this case, the first part 221 and the second part 222 of the conductive adhesive layer 220 may be spaced apart from each other.

A portion of the second opening 25 may be formed at a center of the first part 211 of the shielding film 210, and a remaining portion of the second opening 25 may be formed at a center of the first part 221 of the conductive adhesive layer 220. It is illustrated that the portion of the second opening 25, which is defined by the first part 211 of the shielding film 210, and the remaining portion of the second opening 25, which is defined by the first part 221 of the conductive adhesive layer 220, have the same diameter, but the present disclosure is not limited thereto.

In an embodiment, the first part 211 of the shielding film 210 and the first part 221 of the conductive adhesive layer 220 may be referred to as a first part of the shielding sheet 200. The second part 212 of the shielding film 210 and the second part 222 of the conductive adhesive layer 220 may be referred to as a second part of the shielding sheet 200. The third part 213 of the shielding film 210 and the third part 223 of the conductive adhesive layer 220 may be referred to as a third part of the shielding sheet 200. In another embodiment, when the conductive adhesive layer 220 does not include the third part 223, the third part 213 of the shielding film 210 may be referred to as a third part of the shielding sheet 200.

Additionally, the second part (e.g., the second part 212 of the shielding film 210 and the second part 222 of the conductive adhesive layer 220) of the shielding sheet 200 may be adhered to the heat dissipation member 270 by using a hot melt adhesive. In this case, an adhesive force between the shielding sheet 200 and the heat dissipation member 270 may be further enhanced, and a spacing distance between conductive fillers included in the conductive adhesive layer 220 may be reduced, so that shielding performance may be further enhanced.

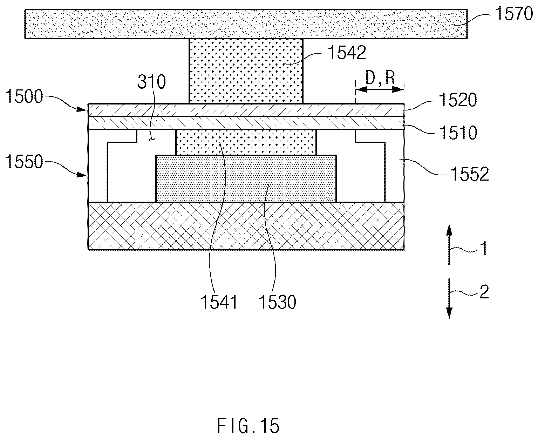

An extent of the second part of the shielding sheet 200 may be greater than an extent of the first part and/or an extent of a cover 252 of the shield can 250 except for the first opening 15. For example, an extent of the second part 222 of the conductive adhesive layer 220 may be greater than an extent of the first part 211 of the shielding film 210. In a comparative embodiment, referring to FIG. 15, because a width D of a cover 1552 of a shield can 1550, in which an opening 310 is formed, is limited, a contact extent R between the shield can 1550 and the shielding sheet 1500 may also be limited. Because of a narrow contact extent between the shield can 1550 and the shielding sheet 1500, a contact resistance may be increased, and thus, shielding performance may be degraded. In contrast, a shielding sheet 200 according to an embodiment may have a low contact resistance because it contacts the heat dissipation member 270 in a wide extent through the second part. Accordingly, shielding performance may be improved.

Furthermore, in a comparative embodiment, referring to FIG. 15, a contact surface between the conductive adhesive layer 1520 and the shield can 1550 may be relatively more vulnerable to leakage of noise generated from the electronic component 1530. In contrast, because the shielding sheet 200 and the shield can 250 directly contact each other, a shielding structure of an electronic device 100 according to an embodiment may have an improved shielding performance. Furthermore, in a comparative embodiment, as a distance between a contact surface between the conductive adhesive layer 1520 and the shield can 1550 and the electronic component 1530 that is a noise source becomes greater, a shielding performance may be improved. In an embodiment, a distance between a contact surface between the conductive adhesive layer 220 and the heat dissipation member 270 and the electronic component 230 that is a noise source may become greater than in the comparative embodiment, due to a height (e.g., a height of the second cavity 20) provided by the shielding sheet 200 and a width (e.g., a width of the second cavity 20) provided by the shielding sheet 200. Accordingly, shielding performance may be improved.

The elastic member 260 may include, for example, a foam formed of a resin, such as polyurethane, cushioning materials, such as a silicone gel, rubber, or an elastomer, but is not limited thereto. The elastic member 260 may absorb mechanical tolerances during assembly, and may absorb external impacts that may be applied during manufacturing and use.

The elastic member 260 may be interposed between the heat dissipation member 270 and the first part of the shielding sheet 200 to provide an elastic force to the first part of the shielding sheet 200. For example, the elastic member 260 may be interposed between the first part 221 of the conductive adhesive layer 220 and the heat dissipation member 270, and may provide an elastic force to the first part 211 of the shielding film 210 in a direction (e.g., a second direction 2) that faces the shield can 250.

The elastic member 260 may be formed to be compressible. A compressible elastic member 260 may absorb mechanical tolerances that occur during a process of assembling the electronic device 100. Furthermore, the elastic member 260 may absorb an impact (e.g., an impact caused by a drop of the electronic device 100) when an external impact is applied, to prevent damage to the electronic component 230.

An elastic force provided by the elastic member 260 may increase an attachment force between the first part 211 of the shielding film 210 and the shield can 250, so that the first part 211 of the shielding film 210 may stably maintain a state, in which it directly contacts the shield can 250. An electrical resistance between the first part 211 of the shielding film 210 and the shield can 250 that directly contact each other may be 0.1 Ω/mm² or less. That is, the shielding film 210 and the shield can 250 may be substantially electrically completely connected to each other. In a comparative embodiment, referring to FIG. 15, the shield can 1550 and the shielding film 1510 may be electrically connected to each other through a separate conductive adhesive layer 1520 interposed therebetween. A structure, in which the shielding film 1510 is electrically indirectly connected to the shield can 1550 through the conductive adhesive layer 1520, may have a high electrical resistance due to an increased thickness and a relatively low electrical conductivity of the conductive adhesive layer 1520. A high electrical resistance may reduce a shielding effect. In contrast, the shielding film 210 and the shield can 250 according to an embodiment may be electrically connected to each other through direct contact thereof, so that a shielding effect may be improved.

The heat dissipation member 270 may be disposed on the shielding sheet 200 (e.g., in the first direction 1). The heat dissipation member 270 may be disposed on the shielding sheet 200 to close the second cavity 20. The heat dissipation member 270 may include at least one of a heat pipe, a vapor chamber (e.g., a vapor chamber 571 or 871 to be described later), a conductive metal sheet (e.g., a copper sheet or an aluminum sheet), a metal bracket (e.g., a support member 143 of FIG. 1B), and/or a metal plate (e.g., a rear plate 111 and/or a cover plate 160 to be described later). Additionally, the heat dissipation member 270 may further include a graphite sheet (e.g., a graphite sheet 573, 673, or 973 to be described later). To be electrically connected to the shielding sheet 200, an area or a portion of the heat dissipation member 270, which contacts the shielding sheet 200, may be formed to be conductive.

The TIM 240 may be formed of a material having high thermal conductivity and low thermal resistance in a liquid phase, a semi-solid phase, or a solid phase. The TIM 240 may include, for example, thermal grease or paste, or a carbon fiber thermal interface material (TIM), but is not limited thereto.

The TIM 240 may be at least partially located in the second cavity 20. For example, an upper portion of the TIM 240 may be located in the second cavity 20, and the remaining portion thereof may be located in the first cavity 10 while passing through the second opening 25 and the first opening 15. The TIM 240 may be disposed between the heat dissipation member 270 and the electronic component 230 to reduce a thermal resistance of a heat transfer path between the heat dissipation member 270 and the electronic component 230. The TIM 240 may contact the heat dissipation member 270 and the electronic component 230 directly to thermally connect them. In a comparative embodiment, referring to FIG. 15, the electronic component 1530 that is a heat source may be thermally connected to the heat dissipation member 1570 through a first TIM 1541, the shielding sheet 1500, and a second TIM 1542. A thermal conductivity of the shielding sheet 1500 may be lower than a thermal conductivity of the TIM 240 according to an embodiment. For example, a thermal conductivity of the shielding sheet 1500 may be about 4 W/mK, and a thermal conductivity of the TIM 240 may be about 28 W/mK, but the thermal conductivity of the TIM 240 is not limited thereto. Furthermore, the thermal resistance of the shielding sheet 1500 may be higher than the thermal resistance of the TIM 240 according to an embodiment. For example, the thermal resistance of the shielding sheet 1500 may be about 0.5 K/W, and the thermal resistance of the TIM 240 may be about 0.138 K/W, but the thermal resistance of the TIM 240 is not limited thereto. That is, because the shielding sheet 1500 having a relatively low thermal conductivity and a relatively high thermal resistance is interposed in a heat transfer path between the electronic component 1530 and the heat dissipation member 1570, heat dissipation performance may be degraded. In contrast, the electronic component 230 and the heat dissipation member 270 according to an embodiment may directly contact the TIM 240 having a relatively low thermal resistance and a high thermal conductivity so that a heat transfer path is formed, whereby heat dissipation performance may be improved.

A shielding structure of an electronic device 100 according to an embodiment may include a printed circuit board 150, a shield can 250, a shielding sheet 200, an elastic member 260, and a heat dissipation member 270. A shielding space of the shielding structure may include a first cavity 10, a second cavity 20, a first opening 15, and a second opening 25. The first opening 15 and the second opening 25 may be understood to be included in the first cavity 10 and the second cavity 20, respectively. An induced current caused by electromagnetic waves generated from the electronic component 230, as illustrated by a dotted arrow, may form a current path, in which it passes through the shield can 250 and the shielding sheet 200 to flow to ground areas of the heat dissipation member 270 and the printed circuit board 150. Through this, noise caused by the electronic component 230 located in the shielding space may be shielded.

A shielding structure of the electronic device 100 according to an embodiment may include a larger shielding space than that of the comparative embodiment illustrated in FIG. 15. For example, in the shielding structure of the electronic device 100, the shielding space may be expanded by the second cavity 20 defined by the shielding sheet 200 and the heat dissipation member 270, and by an empty space 21 defined by the third part 223 of the conductive adhesive layer 220 and the heat dissipation member 270. The shielding space may be expanded by the second cavity 20 defined by the heat dissipation member 270 and each of the first part 221 and the third part 223 of the conductive adhesive layer 220. The expanded shielding space may disperse electromagnetic waves that need to be shielded, so that shielding performance may be improved.

A heat dissipation structure of the electronic device 100 according to an embodiment may include a printed circuit board 150, a TIM 240, and a heat dissipation member 270. The heat generated from the electronic component 230, as illustrated by an arrow, may be dissipated through the TIM 240, the heat dissipation member 270, and the printed circuit board 150. Accordingly, by effectively dissipating the heat of the electronic component 230, overheating of the electronic component 230 may be prevented and normal operations may be ensured. When the heat dissipation member 270 is formed in a plate shape, such as a vapor chamber, the heat dissipation member 270 may contribute to distribution of heat generated from the electronic component 230 to prevent occurrence of a hot spot.

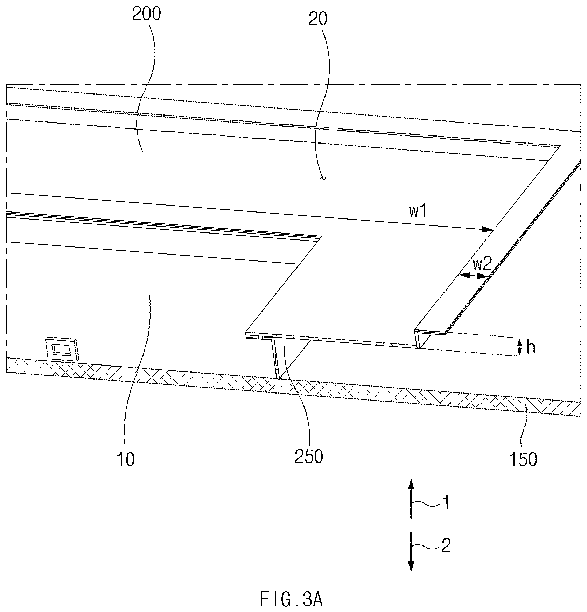

FIG. 3A is a view illustrating factors that affect shielding performance of an electronic device according to an embodiment. Referring to FIG. 3A, in an embodiment, the second cavity 20 defined by the shielding sheet 200 may have a width w1 and a height h. The width w1 may be a length of the second cavity 20 with respect to one direction that is parallel to the printed circuit board 150. The height h may be a length of the second cavity 20 with respect to a direction that is perpendicular to the printed circuit board 150 (e.g., the first direction 1). A width w1 of the second cavity 20 may be formed to be constant. However, this is merely for easily illustrating a change in shielding performance depending on the width w1 of the second cavity 20, and embodiments of the disclosure are not limited thereto. That is, as illustrated in FIG. 3A, a width w1 of the second cavity 20 may be formed to be constant regardless of a height h, or as illustrated in FIG. 2, the width w1 of the second cavity 20 may be formed to increase as the height h increases (toward the first direction 1).

Furthermore, referring to FIG. 3A together with FIG. 2, a contact width w2 may be a width of a portion (e.g., the second part 222 of the conductive adhesive layer 220), at which the shielding sheet 200 is attached to the heat dissipation member 270.

Table 1 below illustrates shielding performance depending on the height h, the width w1, and the contact width w2.

**[Table 1]**

| Classification | Height h [mm] | Width w1 [mm] | Contact width w2 [mm] | Shielding performance [dB] |
|---|---|---|---|---|
| First example | 0 | 15 | 1.0 | 43.5 |
| Second example | 0.5 | 15 | 1.0 | 45.9 |
| Third example | 0.5 | 20 | 1.0 | 47.4 |
| Fourth example | 0.5 | 25 | 1.0 | 49.1 |
| Fifth example | 0.5 | 30 | 1.0 | 50.6 |
| Sixth example | 0.5 | 30 | 1.5 | 53.6 |
| Seventh example | 0.5 | 30 | 2.0 | 55.7 |

Referring to Table 1, shielding performance may be improved as the height h, the width w1, or the contact width w2 increases. However, the height h, the width w1, or the contact width w2 is not limited to those illustrated in Table 1. For example, the contact width w2 may be about 10 mm unlike Table 1, but is not limited thereto.

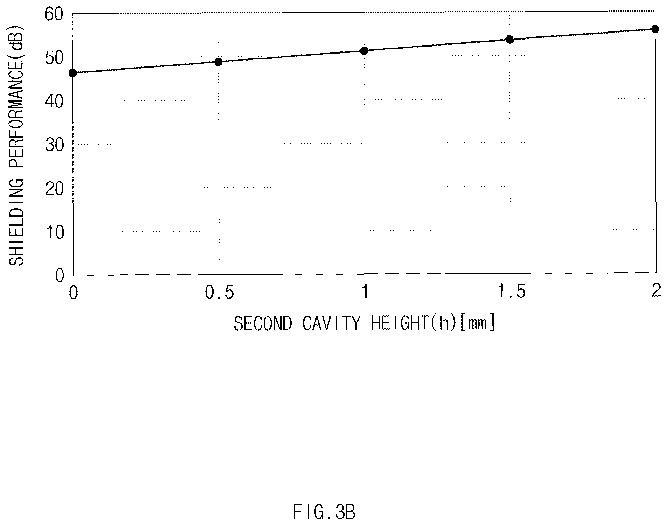

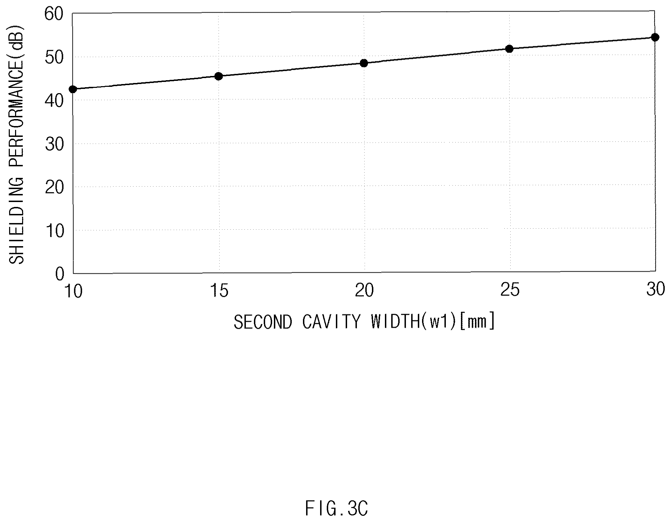

FIG. 3B is a graph depicting shielding performance according to a height h of a second cavity 20. FIG. 3B illustrates results of shielding performance when the width w1 of the second cavity 20 and the contact width w2 are fixed and only the height h is set as a variable. Referring to FIG. 3B, shielding performance may be improved as the height h of the second cavity 20 increases. FIG. 3C is a graph depicting shielding performance according to a width w1 of a second cavity 20. FIG. 3C illustrates results of shielding performance when the height h and the contact width w2 of the second cavity 20 are fixed and only the width w1 of the second cavity 20 is set as a variable. Referring to FIG. 3C, shielding performance may be improved as the width w1 of the second cavity 20 increases. Accordingly, because the shielding structure of the electronic device 100 according to an embodiment includes the shielding space expanded by the second cavity 20, shielding performance may be improved. Although not illustrated, shielding performance may be improved as a width of a portion (e.g., a first part 211 of the shielding film 210 of FIG. 2), at which the shielding sheet 200 is attached to the shield can 250 increases.

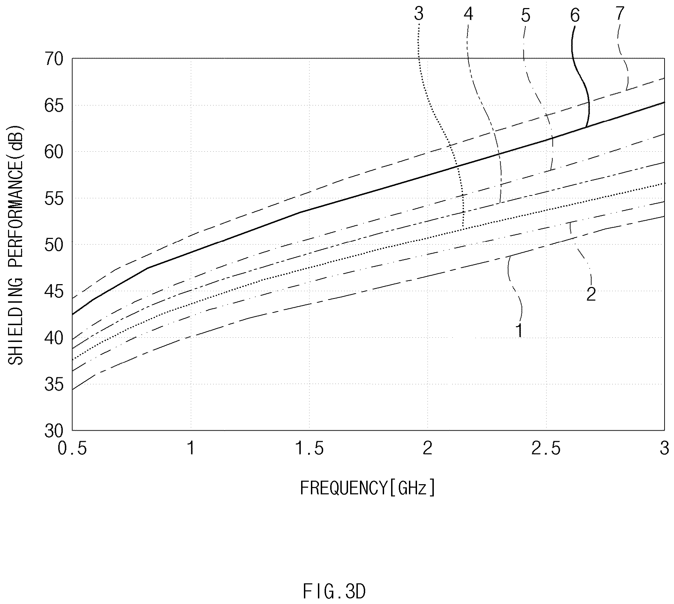

FIG. 3D is a graph depicting shielding performance depending on frequency. Graphs 1 to 7 of FIG. 3D illustrate shielding performance depending on frequencies in the first to seventh examples of Table 1. Referring to FIG. 3D together with Table 1, shielding performance of the first to seventh examples may all be 40 dB or more at frequencies of 1 GHz or higher.

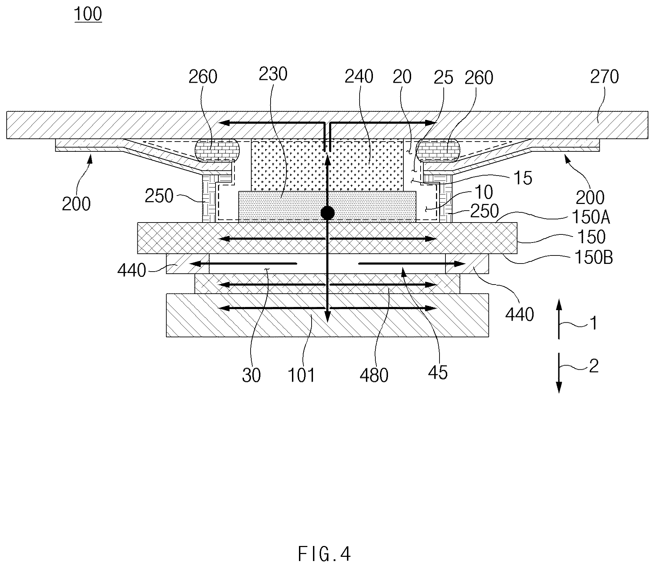

FIG. 4 is a view illustrating a shielding and heat dissipation structure of an electronic device according to an embodiment. Referring to FIG. 4, an electronic device 100 according to an embodiment may include a bracket 440 (e.g., a frame structure 140 of FIG. 1B) and a heat dissipation sheet 480.

The bracket 440 may be disposed on the printed circuit board 150 (e.g., the second direction 2). A second surface 150B of the printed circuit board 150 may be seated on the bracket 440. The bracket 440 may support the printed circuit board 150. A third opening 45 may be formed in the bracket 440. The third opening 45 may at least partially overlap the electronic component 230 with respect to the second direction 2. The third opening 45 may define an air gap between the printed circuit board 150 and the heat dissipation sheet 480. The air gap may be filled with a material, such as a TIM, to improve heat dissipation performance, but is not limited thereto. For example, the third opening 45 may be omitted.

The bracket 440 may include, for example, a support member 143 of FIG. 1B. In this case, the heat dissipation member 270 may not include the support member 143.

The heat dissipation sheet 480 may be disposed on the bracket 440 (e.g., the second direction 2) to close the third opening 45. The heat dissipation sheet 480 may be disposed between the bracket 440 and the display 101. The heat dissipation sheet 480 may include a conductive metal sheet (e.g., a copper sheet) and/or a graphite sheet. When the heat dissipation sheet 480 includes both the conductive metal sheet and the graphite sheet, the graphite sheet may be disposed on the bracket 440, and the conductive metal sheet may be disposed on the graphite sheet to be attached to a rear surface (a surface that faces the first direction 1) of the display 101.

A heat dissipation structure of the electronic device 100 according to an embodiment may further include a bracket 440, a heat dissipation sheet 480, and a display 101. The bracket 440, the heat dissipation sheet 480, and the display 101 may constitute a heat dissipation structure of the electronic device 100 together with the TIM 240 and the heat dissipation member 270. The heat dissipation structure of the electronic device 100 may transfer heat of the electronic component 230, as illustrated by arrows, in a vertical direction (e.g., the first direction 1 and the second direction 2) and a horizontal direction (e.g., a direction that is perpendicular to the first direction 1).

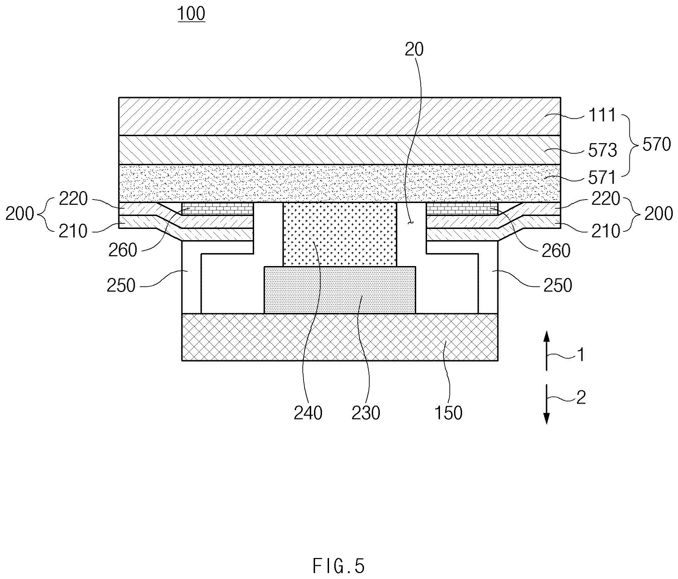

FIG. 5 is a view illustrating a shielding and heat dissipation structure of an electronic device according to an embodiment. Referring to FIG. 5, an electronic device 100 according to an embodiment may include a heat dissipation member 570 (e.g., the heat dissipation member 270 of FIG. 2). In an embodiment, the heat dissipation member 570 may include a vapor chamber 571, a graphite sheet 573, and a rear plate 111.

The vapor chamber 571 may be a component for removing heat generated from the electronic component 230, and may include a sealed case (or an enclosure) and a coolant that is provided in the case. The case may be formed of a material (e.g., copper) having a high thermal conductivity. The coolant may be a component that dissipates heat transferred through the case by a phase change, and may include, for example, water, but is not limited thereto. The vapor chamber 571 may have, for example, a thermal conductivity of about 20,000 W/mK, but is not limited thereto.

The vapor chamber 571 may be disposed on the shielding sheet 200 (e.g., the first direction 1) to close the second cavity 20. The shielding sheet 200 and the TIM 240 may directly contact one surface (e.g., a surface that faces the second direction 2) of the vapor chamber 571. A surface of the vapor chamber 571 may be formed of a conductive metal (e.g., copper) having excellent thermal conductivity and electrical conductivity, so that the vapor chamber 571 may be electrically and thermally connected to the shielding sheet 200 and the TIM 240. The TIM 240 may include a solid TIM, but is not limited thereto. The elastic member 260 may be interposed between the vapor chamber 571 and the shielding sheet 200 to provide an elastic force to the shielding sheet 200.

The graphite sheet 573 may be disposed on the vapor chamber 571 (e.g., in the first direction 1). The graphite sheet 573 may be disposed between the vapor chamber 571 and the rear plate 111. The thermal conductivity of the graphite sheet 573 may be 1,500 W/mK to 1,700 W/mK, but is not limited thereto. The graphite sheet 573 may be vacuum-adhered to the vapor chamber 571. For example, the graphite sheet 573 and the vapor chamber 571 may be stacked, enclosed by a film, and applied with high temperature and high pressure in a vacuum state, and thus, the graphite sheet 573 and the vapor chamber 571 may be vacuum-adhered to each other. An attachment force between the graphite sheet 573 and the vapor chamber 571 may be improved by sealing them with a film.

The vacuum-adhered graphite sheet 573 and vapor chamber 571 may be attached to the rear plate 111. For example, the vacuum-adhered graphite sheet 573 and the vapor chamber 571 may be attached to the rear plate 111 through an adhesive material (not illustrated) interposed between the graphite sheet 573 and the rear plate 111.

Although not illustrated in FIG. 5, a heat dissipation structure of the electronic device 100 according to an embodiment may further include a bracket 440, a heat dissipation sheet 480, and a display 101, which are sequentially disposed on a rear surface (e.g., a second surface 150B) of the printed circuit board 150 as illustrated in FIG. 4.

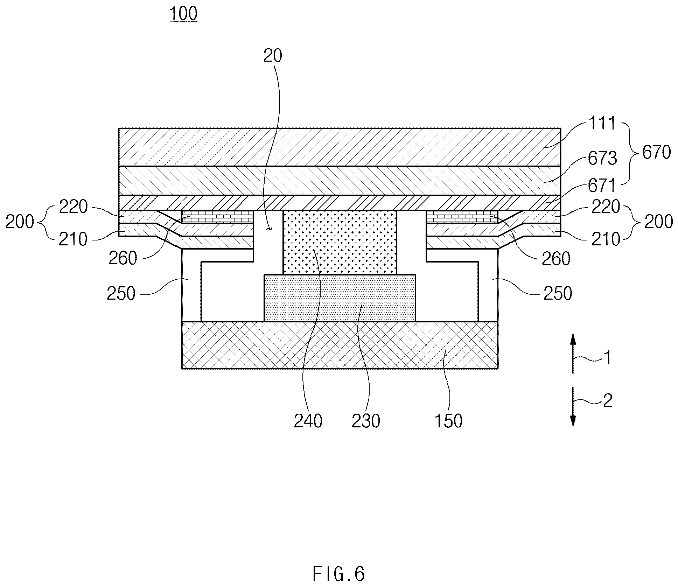

FIG. 6 is a view illustrating a shielding and heat dissipation structure of an electronic device according to an embodiment. Referring to FIG. 6, the electronic device 100 according to an embodiment may include a heat dissipation member 670 (e.g., the heat dissipation member 270 of FIG. 2). In an embodiment, the heat dissipation member 670 may include a conductive layer 671, a graphite sheet 673, and the rear plate 111.

The conductive layer 671 may be disposed between the graphite sheet 673 and the shielding sheet 200. The conductive layer 671 may be disposed on the shielding sheet 200 (e.g., in the first direction 1) to close the second cavity 20. The conductive layer 671 may be formed on one surface (e.g., a surface that faces the second direction 2) of the graphite sheet 673. The conductive layer 671 may directly contact the shielding sheet 200 to be electrically connected thereto. The conductive layer 671 may directly contact the TIM 240 to be thermally connected thereto. The TIM 240 may include a solid TIM, but is not limited thereto.

The conductive layer 671 may include a conductive metal (e.g., copper). The conductive layer 671 may be formed on the one surface of the graphite sheet 673 through a plating process (e.g., wet plating). The conductive layer 671 may have a surface roughness sufficient to facilitate plating. A size of a conductive filler and/or an adhesive material included in the conductive adhesive layer 220 may be adjusted such that the conductive adhesive layer 220 may permeate well into a rough surface of the conductive layer 671.

A thickness of the conductive layer 671 may be 8 µm to 10 µm, but is not limited thereto. An elastic member 260 may be interposed between the conductive layer 671 and the shielding sheet 200 to provide an elastic force to the shielding film 210.

The graphite sheet 673 may be disposed between the conductive layer 671 and the rear plate 111. One surface (e.g., a surface that faces the first direction 1) of the graphite sheet 673 may be attached to the rear plate 111. For example, the graphite sheet 673 may be adhered to the rear plate 111 through an adhesive material (not illustrated), but is not limited thereto.

Although not illustrated in FIG. 6, a heat dissipation structure of the electronic device 100 according to an embodiment may further include a bracket 440, a heat dissipation sheet 480, and a display 101, which are sequentially disposed on a rear surface (e.g., a second surface 150B) of the printed circuit board 150 as illustrated in FIG. 4.

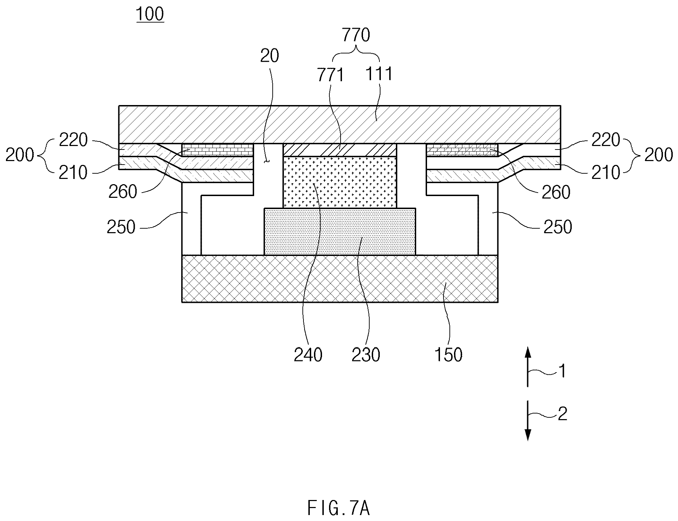

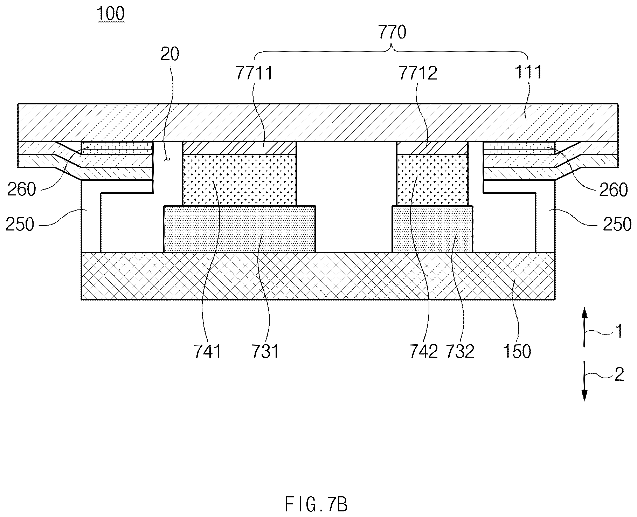

FIG. 7A is a view illustrating a shielding and heat dissipation structure of an electronic device according to an embodiment. FIG. 7B is a view illustrating a shielding and heat dissipation structure of an electronic device according to an embodiment.

Referring to FIG. 7A, the electronic device 100 according to an embodiment may include a heat dissipation member 770 (e.g., the heat dissipation member 270 of FIG. 2). In an embodiment, the heat dissipation member 770 may include the rear plate 111 and a conductive block (or a conductive sheet) 771.

The rear plate 111 may be disposed on the shielding sheet 200 (e.g., in the first direction 1) to close the second cavity 20. The rear plate 111 may directly contact the shielding sheet 200. The rear plate 111 may be formed to have conductivity to be electrically connected to the shielding sheet 200. An elastic member 260 may be interposed between the rear plate 111 and the shielding sheet 200. The elastic member 260 may provide an elastic force to the shielding sheet 200.

The conductive block 771 may be formed of a conductive metal (e.g., copper) having excellent thermal conductivity. The conductive block 771 may be disposed between the TIM 240 and the rear plate 111. The conductive block 771 may be at least partially located in the second cavity 20. Heat generated from the electronic component 230 may be transferred to the TIM 240, the conductive block 771, and the rear plate 111. A thickness of the conductive block 771 may be 20 µm to 50 µm, but is not limited thereto. The conductive block 771 may be attached to the rear plate 111. For example, the conductive block 771 may be welded or soldered to the rear plate 111 by using an induction heating method.

In an embodiment, the TIM 240 may be formed in a solid state. The TIM 240 formed in a solid state may be attached to the conductive block 771. For example, the TIM 240 may be adhered to the conductive block 771 through an adhesive material. In another embodiment, the TIM 240 may be formed in a liquid or semi-solid state. Because a thickness provided by the conductive block 771 may reduce a length of a thermal path that the TIM 240 has to provide, a problem caused by fluidity may be prevented even when the TIM 240 is formed in a liquid or semi-solid state.

In another embodiment, the rear plate 111 may be replaced with a vapor chamber, or a vapor chamber and a graphite sheet may be interposed between the rear plate 111 and the conductive block 771.

In another embodiment, each of the electronic component 230, the TIM 240, and the conductive block 771 may be provided in a plurality. For example, referring to FIG. 7B, a first electronic component 731 and a second electronic component 732 may be disposed in the shield can 250. In addition, a first TIM 741 may be disposed on the first electronic component 731 (e.g., in the first direction 1), and a second TIM 742 may be disposed on the second electronic component 732 (e.g., in the first direction 1). A first conductive block 7711 may be disposed between the first TIM 741 and the rear plate 111, and a second conductive block 7712 may be disposed between the second TIM 742 and the rear plate 111.

Although not illustrated in FIGS. 7A and 7B, a heat dissipation structure of the electronic device 100 according to an embodiment may further include a bracket 440, a heat dissipation sheet 480, and a display 101, which are sequentially disposed on a rear surface (e.g., a second surface 150B) of the printed circuit board 150 as illustrated in FIG. 4.

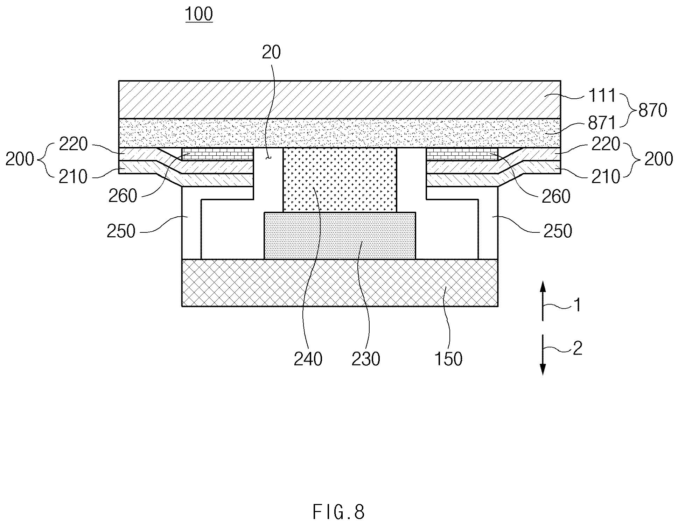

FIG. 8 is a view illustrating a shielding and heat dissipation structure of an electronic device 100 according to an embodiment. Referring to FIG. 8, the electronic device 100 according to an embodiment may include a heat dissipation member 870 (e.g., the heat dissipation member 270 of FIG. 2). The heat dissipation member 870 may include a vapor chamber 871 and the rear plate 111.

The vapor chamber 871 may be disposed on the shielding sheet 200 (e.g., in the first direction 1) to close the second cavity 20. The vapor chamber 871 may directly contact the shielding sheet 200 to be electrically connected thereto. The vapor chamber 871 may directly contact the TIM 240 to be thermally connected thereto.

The vapor chamber 871 may be disposed between the TIM 240 and the rear plate 111. The vapor chamber 871 may be attached to one surface (e.g., a surface that faces the second direction 2) of the rear plate 111. For example, the vapor chamber 871 may be adhered to the one surface of the rear plate 111 through a welding process. The rear plate 111 may be formed of a conductive material to be weldable.

Although not illustrated in FIG. 8, a heat dissipation structure of the electronic device 100 according to an embodiment may further include a bracket 440, a heat dissipation sheet 480, and a display 101, which are sequentially disposed on a rear surface (e.g., a second surface 150B) of the printed circuit board 150 as illustrated in FIG. 4.

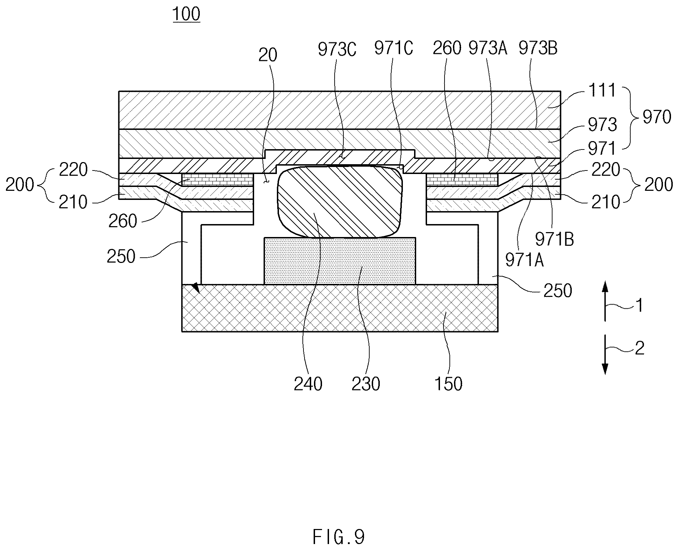

FIG. 9 is a view illustrating a shielding and heat dissipation structure of an electronic device according to an embodiment. Referring to FIG. 9, the electronic device 100 according to an embodiment may include a heat dissipation member 970. The heat dissipation member 970 may include a conductive layer 971, a graphite sheet 973, and the rear plate 111.

The conductive layer 971 may include a first surface 971A and a second surface 971B. The first surface 971A may face the electronic component 230 (e.g., the second direction 2), and the second surface 971B may face a direction (e.g., the first direction 1) that is opposite to the first surface 971A.

The conductive layer 971 may be disposed on the shielding sheet 200 (e.g., in the first direction 1) to close the second cavity 20. The conductive layer 971 may be disposed between the graphite sheet 973 and the shielding sheet 200. The conductive layer 971 may be formed on a first surface 973A (e.g., a surface that faces the second direction 2) of the graphite sheet 973. The first surface 971A of the conductive layer 971 may directly contact the shielding sheet 200 to be electrically connected thereto. Furthermore, the first surface 971A of the conductive layer 971 may directly contact the TIM 240 to be thermally connected thereto.

The conductive layer 971 may include a conductive metal (e.g., copper). The conductive layer 971 may be formed on a first surface 973A of the graphite sheet 973 through a plating process (e.g., wet plating). A thickness of the conductive layer 971 may be 8 µm to 10 µm, but is not limited thereto. An elastic member 260 may be interposed between the conductive layer 971 and the shielding sheet 200 to provide an elastic force to the shielding film 210.

The graphite sheet 973 may be disposed between the conductive layer 971 and the rear plate 111. The graphite sheet 973 may include a first surface 973A and a second surface 973B. The first surface 973A may face the electronic component 230 (e.g., the second direction 2), and the second surface 973B may face a direction (e.g., the first direction 1) that is opposite to the first surface 973A. The second surface 973B of the graphite sheet 973 may be attached to the rear plate 111. For example, the graphite sheet 973 may be adhered to the rear plate 111 through an adhesive material (not illustrated), but is not limited thereto.

The TIM 240 may include a liquid TIM or a semi-solid TIM. The TIM 240 may be accommodated in a second groove 971C formed in the conductive layer 971.

A first groove 973C may be formed in a first surface 973A of the graphite sheet 973. For example, the first groove 973C may be formed by pressing a fabric of the graphite sheet 973 with a jig.

A second groove 971C may be formed in a first surface 971A of the conductive layer 971. The second groove 971C may be formed at a position corresponding to the first groove 973C. For example, the second groove 971C may at least partially overlap the first groove 973C with respect to the first direction 1. The second groove 971C may prevent a liquid TIM 240 accommodated in the second groove 971C from spreading. The second groove 971C may be formed as the conductive layer 971 is plated with a substantially uniform thickness on a first surface 973A of the graphite sheet 973, in which the first groove 973C is formed. The second groove 971C may be opened toward the electronic component 230 to communicate with the second cavity 20. A shielding space may be secured to be larger by sizes of the second cavity 20 and the second groove 971C. The expanded shielding space may disperse electromagnetic waves that need to be shielded, so that shielding performance may be improved.

Although not illustrated in FIG. 9, a heat dissipation structure of the electronic device 100 according to an embodiment may further include a bracket 440, a heat dissipation sheet 480, and a display 101, which are sequentially disposed on a rear surface (e.g., a second surface 150B) of the printed circuit board 150 as illustrated in FIG. 4.

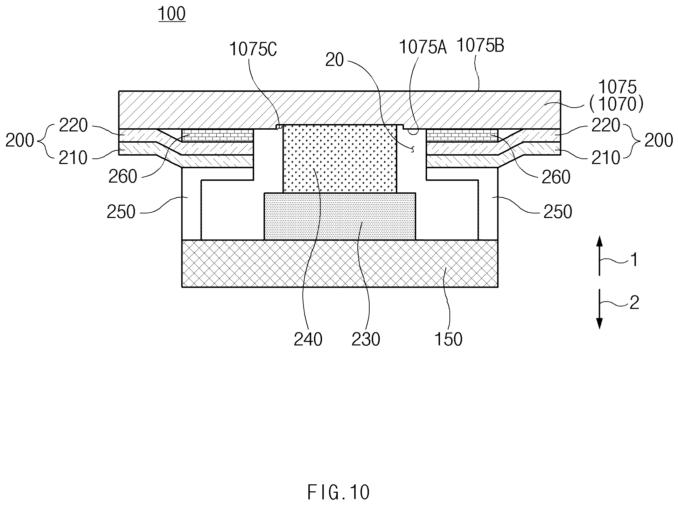

FIG. 10 is a view illustrating a shielding and heat dissipation structure of an electronic device according to an embodiment. Referring to FIG. 10, the electronic device 100 according to an embodiment may include a heat dissipation member 1070. The heat dissipation member 1070 may include a rear plate 1075 (e.g., the rear plate 111).

The rear plate 1075 may be disposed on the shielding sheet 200 (e.g., in the first direction 1) to close the second cavity 20. The rear plate 1075 may include a first surface 1075A that faces the electronic component 230 (e.g., in the second direction 2), and a second surface 1075B (e.g., the rear surface 100B of FIG. 1A) that faces a direction (e.g., in the first direction 1) that is opposite to the first surface 1075A. A first surface 1075A of the rear plate 1075 may directly contact the shielding sheet 200 and the TIM 240 to be electrically and thermally connected thereto. An elastic member 260 may be interposed between the rear plate 1075 and the shielding sheet 200.

A recess 1075C that provides a step may be formed in a first surface 1075A of the rear plate 1075. For example, the recess 1075C may be formed by mechanically processing a first surface 1075A of the rear plate 1075.

The TIM 240 may be seated in the recess 1075C. The TIM 240 may be formed as a liquid, a semi-solid, or a solid. The recess 1075C that provides a step may prevent the TIM 240 formed as a liquid or a semi-solid from spreading after being applied. Furthermore, the recess 1075C may guide a position, at which the TIM 240 formed as a solid is assembled, and prevent it from being displaced from the correct position. Furthermore, the recess 1075C may be opened toward the electronic component 230 to communicate with the second cavity 20. A shielding space may be secured to be larger by sizes of the second cavity 20 and the recess 1075C. The expanded shielding space may disperse electromagnetic waves that need to be shielded, so that shielding performance may be improved.

Although not illustrated in FIG. 10, a heat dissipation structure of the electronic device 100 according to an embodiment may further include a bracket 440, a heat dissipation sheet 480, and a display 101, which are sequentially disposed on a rear surface (e.g., a second surface 150B) of the printed circuit board 150 as illustrated in FIG. 4.

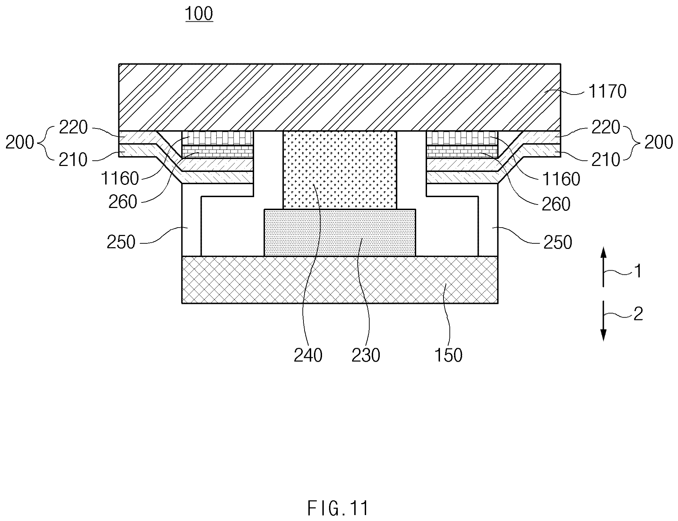

FIG. 11 is a view illustrating a shielding and heat dissipation structure of an electronic device according to an embodiment. Referring to FIG. 11, an elastic member 260 of the electronic device 100 according to an embodiment may be bonded to a heat dissipation member 1170 through a bonding layer 1160. For example, the elastic member 260 may be soldered to the heat dissipation member 1170 by plating the elastic member 260, applying a solder paste, seating it on the heat dissipation member 1170, and then locally induction heating it. The bonding layer 1160 may be formed by melting a plating layer of the elastic member 260 together with a solder paste.

The heat dissipation member 1170 may, for example, include the above-described heat dissipation member 570, 670, 770, 870, 970, or 1070.

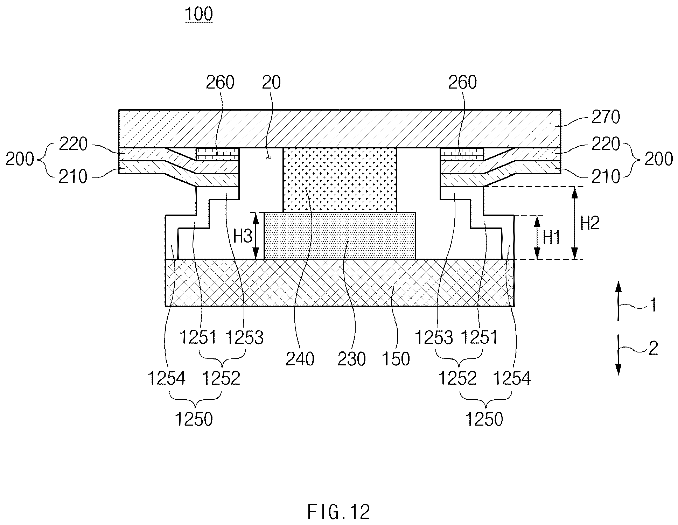

FIG. 12 is a view illustrating a shielding and heat dissipation structure of an electronic device according to an embodiment. Referring to FIG. 12, the electronic device 100 according to an embodiment may include a shield can 1250 (e.g., the shield can of FIG. 2).

The shield can 1250 may include a sidewall 1254 and a cover 1252 that covers the sidewall 1254.

In an embodiment, the sidewall 1254 may be formed to be lower than a height H3 of the electronic component 230. The cover 1252 may be formed in a stepwise shape to have steps. For example, the cover 1252 may include a first cover 1251 and a second cover 1253 that are located at different heights. The first cover 1251 may be located at a first height H1 from the printed circuit board 150. The first cover 1251 may be located at the first height H1 that is lower than the third height H3 of the electronic component. The second cover 1253 may be located at a second height H2 from the printed circuit board 150, which is higher than the first height H1 and the third height H3.

Because the second cover 1253 is located at the second height H2 that is higher than the first cover 1251 to contact the shielding sheet 200, the cover 1252 may secure a contact extent with the shielding sheet 200.

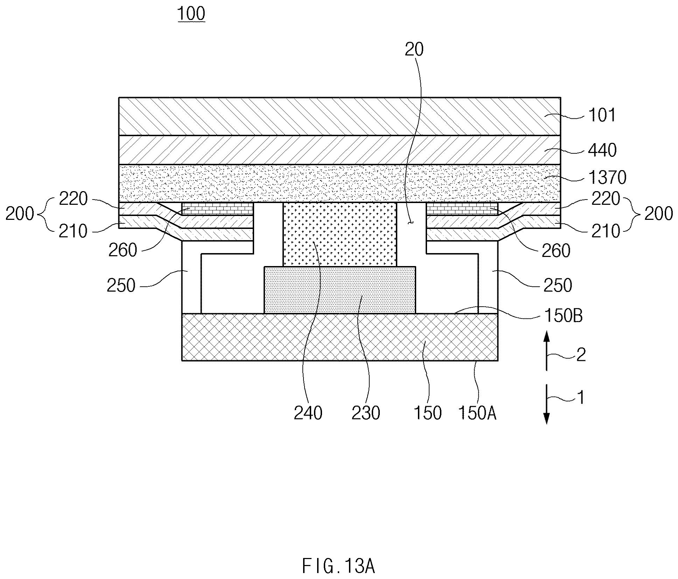

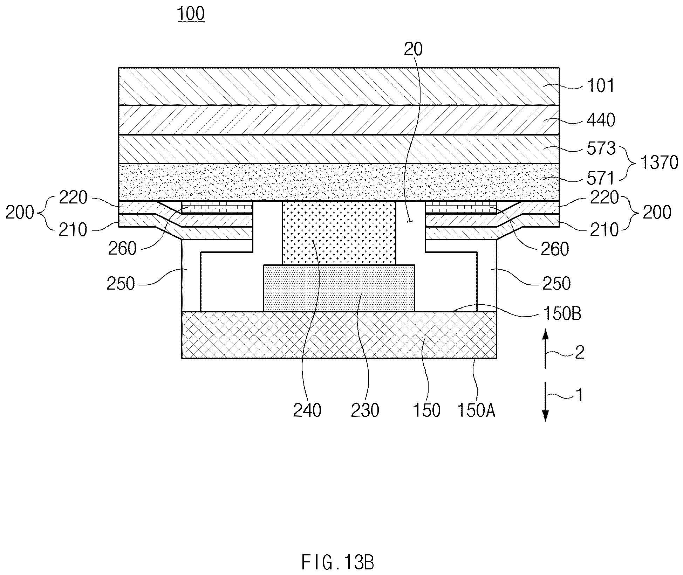

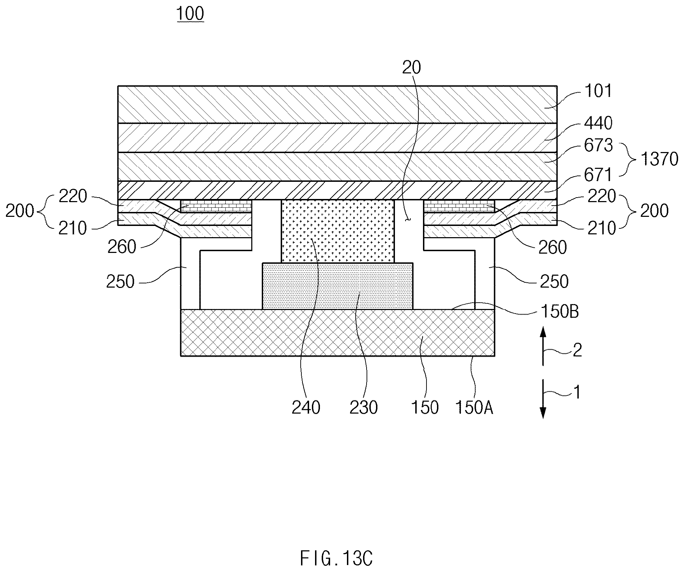

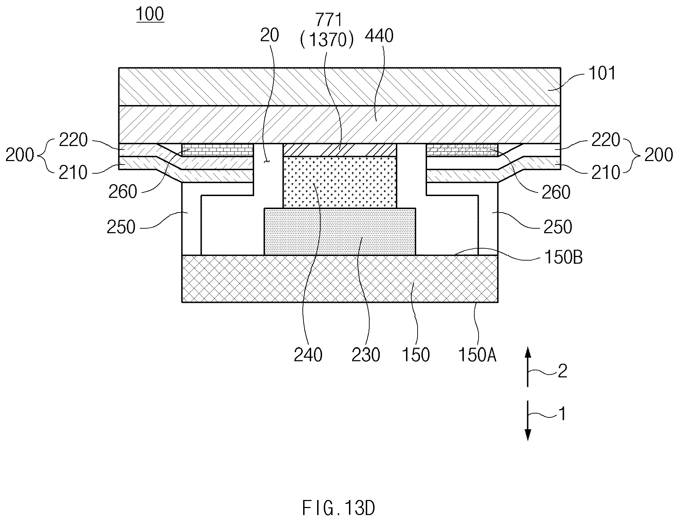

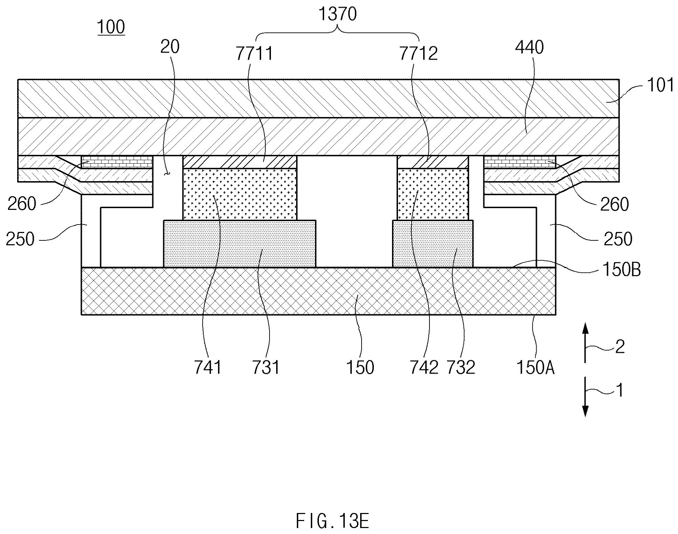

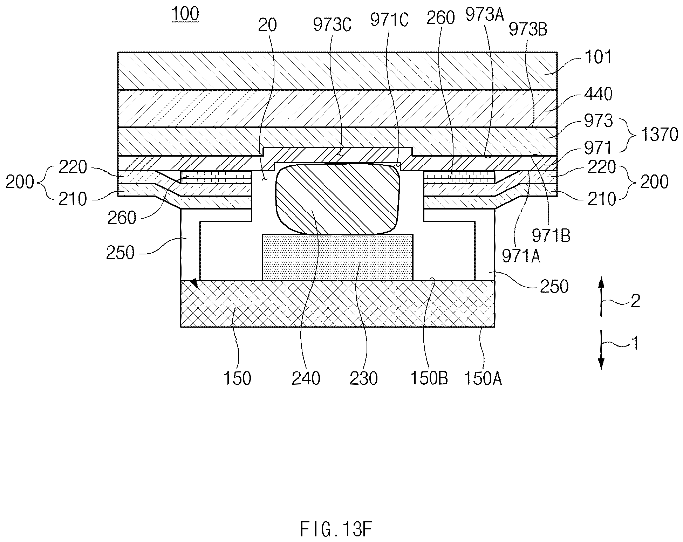

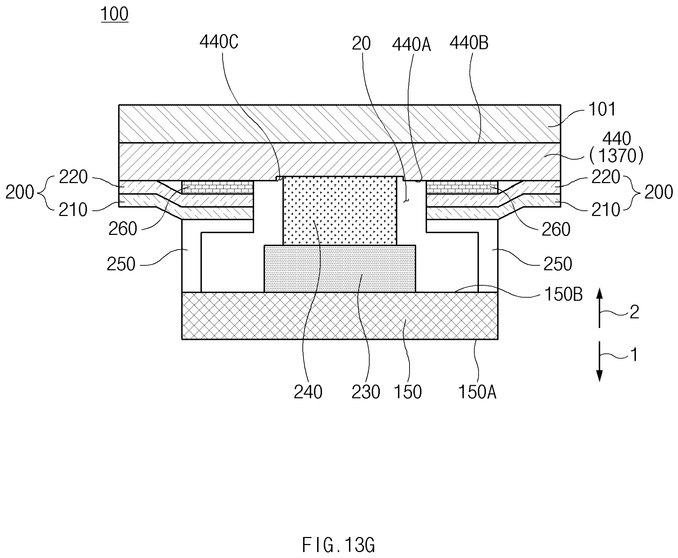

FIGS. 13A to 13H are views illustrating a shielding and heat dissipation structure of an electronic device according to an embodiment. Referring to FIGS. 13A to 13H, the electronic device 100 according to an embodiment may include a shielding sheet 200 and a heat dissipation member 1370 that are disposed between the printed circuit board 150 and the display 101. As an example, the electronic device 100 may include a shield can 250, a shielding sheet 200, a heat dissipation member 1370, a bracket 440, and a display 101 that are sequentially disposed on a second surface 150B of the printed circuit board 150. In the shield can 250, an electronic component (e.g., the electronic component 230 of FIGS. 13A, 13B, 13C, 13D, 13F, and 13G, and the electronic components 731 and 730 of FIG. 13E) may be disposed, and a TIM (e.g., the TIM 240 of FIGS. 13A, 13B, 13C, 13D, 13F, and 13G, and the TIMs 741 and 742 of FIG. 13E) may be disposed on the electronic component (e.g., in the second direction 2).

Referring to FIG. 13A, the electronic device 100 according to an embodiment may include a heat dissipation member 1370 that is disposed between the bracket 440 and the shielding sheet 200. The heat dissipation member 1370 may include at least one of a heat pipe, a vapor chamber (e.g., the vapor chamber 571 of FIG. 5), a conductive metal sheet (e.g., a copper sheet or an aluminum sheet), and/or a metal bracket (e.g., the support member 143 of FIG. 1B).

Referring to FIG. 13B, the heat dissipation member 1370 according to an embodiment may include a vapor chamber 571 (e.g., the vapor chamber 571 of FIG. 5) and a graphite sheet 573 (e.g., the graphite sheet 573 of FIG. 5). The graphite sheet 573 and the vapor chamber 571 may be vacuum-adhered to each other. The vacuum-adhered graphite sheet 573 and vapor chamber 571 may be attached to the bracket 440 to face the display 101. For example, the vacuum-adhered graphite sheet 573 and the vapor chamber 571 may be attached to the bracket 440 through an adhesive material (not illustrated) interposed between the graphite sheet 573 and the bracket 440.

Referring to FIG. 13C, the heat dissipation member 1370 according to an embodiment may include a conductive layer 671 (e.g., the conductive layer 671 of FIG. 6) and a graphite sheet 673 (e.g., the graphite sheet 673 of FIG. 6). The conductive layer 671 may directly contact the shielding sheet 200 to be electrically connected thereto. The conductive layer 671 may directly contact the TIM 240 to be thermally connected thereto. The graphite sheet 673 may be disposed between the conductive layer 671 and the bracket 440. One surface (e.g., a surface that faces the second direction 2) of the graphite sheet 673 may be attached to the bracket 440 to face the display 101.

Referring to FIG. 13D, the heat dissipation member 1370 according to an embodiment may include a conductive block (or a conductive sheet) 771 (e.g., the conductive block 771 of FIG. 7A). The conductive block 771 may be formed of a conductive metal (e.g., copper) having excellent thermal conductivity. The conductive block 771 may be disposed between the TIM 240 and the bracket 440.

Referring to FIG. 13E, each of the electronic components 731 and 732 (e.g., the electronic components 731 and 732 of FIG. 7B), the TIMs 741 and 742 (e.g., the TIMs 741 and 742 of FIG. 7B), and the conductive blocks 7711 and 7712 (e.g., the conductive blocks 7711 and 7712 of FIG. 7B) may be configured in a plurality. A first TIM 741 may be disposed on the first electronic component 731 (e.g., in the second direction 2), and a second TIM 742 may be disposed on the second electronic component 732 (e.g., in the second direction 2). A first conductive block 7711 may be disposed between the first TIM 741 and the bracket 440, and a second conductive block 7712 may be disposed between the second TIM 742 and the bracket 440.

Referring to FIG. 13F, the heat dissipation member 1370 according to an embodiment may include a conductive layer 971 (e.g., the conductive layer 971 of FIG. 9) and a graphite sheet 973 (e.g., the graphite sheet 973 of FIG. 9). The conductive layer 971 may include a first surface 971A and a second surface 971B. The first surface 971A may face the electronic component 230 (e.g., in the first direction 1), and the second surface 971B may face the display 101 in a direction (e.g., the second direction 2) that is opposite to the first surface 971A. A second groove 971C may be formed in a first surface 971A of the conductive layer 971. The second groove 971C may prevent a liquid TIM 240 accommodated in the second groove 971C from spreading. Furthermore, the second groove 971C may be opened toward the electronic component 230 to communicate with the second cavity 20. A shielding space may be secured to be larger by sizes of the second cavity 20 and the second groove 971C. The expanded shielding space may disperse electromagnetic waves that need to be shielded, so that shielding performance may be improved.

The graphite sheet 973 may be disposed between the conductive layer 971 and the bracket 440. The graphite sheet 973 may include a first surface 973A and a second surface 973B. The first surface 973A may face the electronic component 230 (e.g., in the first direction 1), and the second surface 973B may face the display 101 in a direction (e.g., the second direction 2) that is opposite to the first surface 973A. A second surface 973B of the graphite sheet 973 may be attached to the bracket 440.

Referring to FIG. 13G, the heat dissipation member 1370 according to an embodiment may include a bracket 440. The bracket 440 may be disposed between the display 101 and the shielding sheet 200 to close the second cavity 20. The bracket 440 may include a first surface 440A that faces the electronic component 230 (e.g., in the first direction 1), and a second surface 440B (e.g., a front surface 100A of FIG. 1A) that faces a direction (e.g., the second direction 2) opposite to the first surface 440A. The first surface 440A of the bracket 440 may directly contact the shielding sheet 200 and TIM 240 to be electrically and thermally connected thereto. An elastic member 260 may be interposed between the bracket 440 and the shielding sheet 200.

A recess 440C that provides a step may be formed in the first surface 440A of the bracket 440. The TIM 240 may be seated in the recess 440C. The TIM 240 may be formed as a liquid, a semi-solid, or a solid. The recess 440C that provides a step may prevent the TIM 240 formed as a liquid or a semi-solid from spreading after being applied. Furthermore, the recess 440C may guide a position, at which the TIM 240 formed as a solid is assembled, and prevent it from being displaced from the correct position. Furthermore, the recess 440C may be opened toward the electronic component 230 to communicate with the second cavity 20. A shielding space may be secured to be larger by sizes of the second cavity 20 and the recess 440C. The expanded shielding space may disperse electromagnetic waves that need to be shielded, so that shielding performance may be improved.

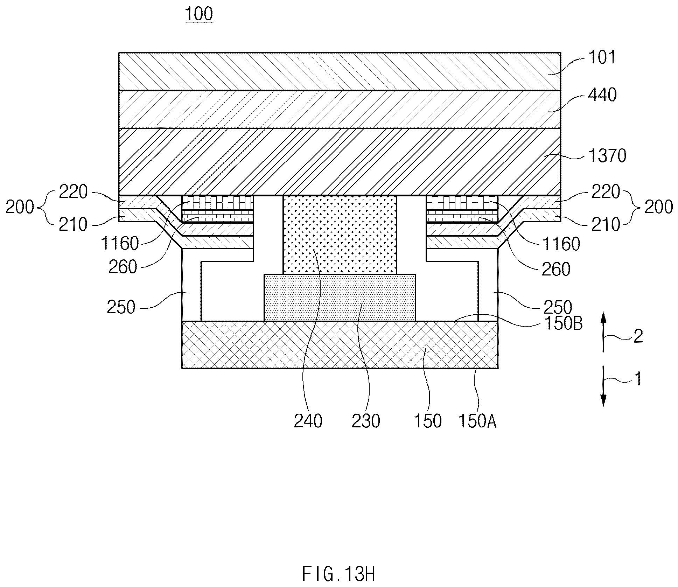

Referring to FIG. 13H, an elastic member 260 of the electronic device 100 according to an embodiment may be bonded to a heat dissipation member 1370 through a bonding layer 1160. As an example, the bonding layer 1160 may be formed by melting a plating layer of the elastic member 260 together with a solder paste. The heat dissipation member 1370 may include, for example, the heat dissipation member 1370 of FIGS. 13A to 13G described above.

The shielding and heat dissipation structure of the above-described electronic device is not limited to the embodiments described in each drawing, and the shielding and heat dissipation structures described in each drawing may be applied in combination with each other. For example, in an electronic device according to an embodiment, only a plurality of the shielding and heat dissipation structures described in FIGS. 2 and 4 to 11 may be employed, only a plurality of the shielding and heat dissipation structures described in FIGS. 13A to 13H may be employed, or the shielding and heat dissipation structures described in FIGS. 2 and 4 to 11 and the shielding and heat dissipation structures described in FIGS. 13A to 13H may be employed in combination.

The first opening and the size of the electronic component described in FIG. 2 may be applied to at least any one of the shielding and heat dissipation structures described in FIGS. 2, 4 to 11, and 13A to 13H. Variables that affect the shielding performance described in FIG. 3A may be applied to at least one of the shielding and heat dissipation structures described in FIGS. 2, 4 to 11, and 13A to 13H. Furthermore, the structure of the shield can described in FIG. 12 may be applied to at least any one of the shielding and heat dissipation structures described in FIGS. 2, 4 to 11, and 13A to 13H.

As described above, the electronic device 100 according to an embodiment of the disclosure may include a printed circuit board 150, a shield can 250 that is disposed on the printed circuit board 150 to define a first cavity, and has a first opening 15 that communicates with the first cavity at an upper portion thereof, an electronic component 230 that is disposed on the printed circuit board 150, and is located in the first cavity 10, a shielding sheet 200 that is disposed at an upper portion of the shield can 250, communicates with the first cavity 10 through the first opening 15 of the shield can 250, and defines a second cavity 20 having an opened upper side, wherein the shielding sheet 200 includes a first part 211 and 221 that contacts the upper portion of the shield can 250, a heat dissipation member 270, 570, 670, 770, 870, 970, 1070, and 1170 that is disposed on the shielding sheet 200 to close the opened upper side of the second cavity 20, a thermal interface material (TIM) 240 that is disposed between the heat dissipation member 270, 570, 670, 770, 870, 970, 1070, and 1170 and the electronic component 230, and an elastic member 260 that is disposed between the first part 211 and 221 of the shielding sheet 200 and the heat dissipation member 270, 570, 670, 770, 870, 970, 1070, and 1170 in the second cavity 20, and provides an elastic force to the first part 211 and 221, the shield can 250, the shielding sheet 200, and the heat dissipation member 270, 570, 670, 770, 870, 970, 1070, and 1170 may be electrically connected to each other, the electronic component 230, the TIM 240, and the heat dissipation member 270, 570, 670, 770, 870, 970, 1070, and 1170 may be thermally connected to each other, the first cavity 10 may have a first width along a direction that is parallel to the printed circuit board 150, the second cavity 20 may have a second width along a direction that is parallel to the printed circuit board 150, and the second width may be greater than the first width.

According to an embodiment, the first part 211 and 221 of the shielding sheet 200 may directly contact the upper portion of the shield can 250.

According to an embodiment, the shielding sheet 200 may include a shielding film 210 and a conductive adhesive layer 220, and the conductive adhesive layer 220 may be located between the shielding film 210 and the heat dissipation member 270, 570, 670, 770, 870, 970, 1070, and 1170.

According to an embodiment, the shielding film 210 may include a first part 211 that directly contacts the upper portion of the shield can 250, and the conductive adhesive layer 220 may include a first part 221 that is interposed between the first part 211 of the shielding film 210 and the elastic member 260 to attach the first part 211 of the shielding film 210 to the elastic member 260.

According to an embodiment, the shielding sheet 200 may include a second part 212 and 222 that directly contacts the heat dissipation member 270, 570, 670, 770, 870, 970, 1070, and 1170.

According to an embodiment, the shielding film 210 may include a second part 212 that is located in the shield can 250 to be more distant than the first part 211 with respect to a direction that is parallel to the printed circuit board 150, and a third part 213 that connects the first part 211 and the second part 212, the conductive adhesive layer 220 may include a second part 222 that is disposed between the second part 212 of the shielding film 210 and the heat dissipation member 270, 570, 670, 770, 870, 970, 1070, and 1170 to attach the second part 212 of the shielding film 210 to the heat dissipation member 270, 570, 670, 770, 870, 970, 1070, and 1170, and the first part 221 and the second part 222 of the conductive adhesive layer 220 may be spaced apart from each other.

According to an embodiment, the conductive adhesive layer 220 may include a third part 223 that connects the first part 221 and the second part 222 of the conductive adhesive layer 220.

According to an embodiment, an extent of the second part 222 of the conductive adhesive layer 220 may be greater than an extent of the first part 211 of the shielding film 210.

According to an embodiment, the shielding film 210 may not include an adhesive material.

According to an embodiment, the TIM 240 may directly contact the electronic component 230 and the heat dissipation member 270, 570, 670, 770, 870, 970, 1070, and 1170.

According to an embodiment, the electronic device may further include a rear plate 111 that faces a first surface of the printed circuit board 150, and a bracket 101 that faces a second surface of the printed circuit board 150 that is opposite to the first surface, and the heat dissipation member 570 may include a vapor chamber 571 that is disposed on the shielding sheet 200 to close the second cavity, and has a conductive surface, and a graphite sheet 573 that is disposed between at least any one of the rear plate 111 and the bracket 101, and the vapor chamber 571, and the vapor chamber 571 and the graphite sheet 573 may be adhered to each other.

According to an embodiment, the electronic device may further include a rear plate 111 that faces a first surface of the printed circuit board 150, and a bracket 101 that faces a second surface of the printed circuit board 150 that is opposite to the first surface, and the heat dissipation member 670 may include a conductive layer 671 that is disposed on the shielding sheet 200 to close the opened upper side of the second cavity 20, and a graphite sheet 673 that is disposed between at least any one of the rear plate 111 and the bracket 101 and the conductive layer 671.

According to an embodiment, the electronic device may further include a rear plate 111 that faces a first surface of the printed circuit board 150, and a bracket 101 that faces a second surface of the printed circuit board 150 that is opposite to the first surface, and a conductive block 771 that is disposed between at least any one of the rear plate 111 and the bracket 101 and the TIM 240.

According to an embodiment, the electronic device may further include a rear plate 111 that faces a first surface of the printed circuit board 150, and a bracket 101 that faces a second surface of the printed circuit board 150 that is opposite to the first surface, and the heat dissipation member 870 may include a rear plate 111 that defines a rear surface 100B of the electronic device 100, and a vapor chamber 871 that is welded to at least any one of the rear plate 111 and the bracket, and is disposed at an upper portion of the shielding sheet 200 to close the opened upper side of the second cavity 20.

According to an embodiment, the electronic device may further include a rear plate 111 that faces a first surface of the printed circuit board 150, and a bracket 101 that faces a second surface of the printed circuit board 150 that is opposite to the first surface, and the heat dissipation member 970 may include a rear plate 111 that defines a rear surface 100B of the electronic device 100, a graphite sheet 973 that is attached to at least any one of the rear plate 111 and the bracket, and has a first groove 973C that is defined on a first surface 973A that faces the electronic component 230, and a conductive layer 971 that is formed on the first surface 973A of the graphite sheet 973, and has a second groove 971C formed in one surface 971A that faces the electronic component 230 to correspond to a position of the first groove 973C, and the TIM 240 may be accommodated in the second groove 971C.

According to an embodiment, the electronic device may further include a rear plate 111 that faces a first surface of the printed circuit board 150, and a bracket 101 that faces a second surface of the printed circuit board 150 that is opposite to the first surface, and a rear plate 111 that defines a rear surface 100B of the electronic device 100, and is disposed on the shielding sheet 200 to close the opened upper side of the second cavity 20, and at least any one of the rear plate 111 and the bracket may include a recess 1075C that is formed on a first surface 1075B that faces the electronic component 230, and the TIM 240 may be seated in the recess 1075C.

According to an embodiment, the elastic member 260 may be soldered to the heat dissipation member 270, 570, 670, 770, 870, 970, 1070, and 1170.

According to an embodiment, The shielding sheet 200 may include a second part 212 and 222 that contacts the heat dissipation member 270, 570, 670, 770, 870, 970, 1070, and 1170, and the second part 212 and 222 may be adhered to the heat dissipation member 270, 570, 670, 770, 870, 970, 1070, and 1170 by using a hot melt adhesive (HMA).

According to an embodiment, the heat dissipation member 270 may include a vapor chamber, a heat pipe, or a conductive plate.

According to an embodiment, the electronic device may further include a bracket 440 including a third opening 45 that overlaps the electronic component 230, a heat dissipation sheet 480 that is disposed on the bracket 440 to close the third opening 45, and a display 101 that disposed on the heat dissipation sheet 480, the printed circuit board 150 includes a first surface 150A and a second surface 150B that faces an opposite direction to the first surface 150A, the electronic component 230 and the shield can 250 are disposed on at least any one of the first surface 150A and the second surface 150B of the printed circuit board 150, and the bracket 440 may be disposed on the second surface 150B of the printed circuit board 150.

An electronic device 100 according to an embodiment of the disclosure may include a display 101, a printed circuit board 150, a shielding sheet 200 and a heat dissipation member 1370 that are disposed between the display 101 and the printed circuit board 150, a shield can 250 that is disposed on the printed circuit board 150 and defines a first cavity 10, and a thermal interface material (TIM) 240 that is disposed between the heat dissipation member 1370 and the electronic component 230, and the shield can 250, the shielding sheet 200, and the heat dissipation member 1370 may be electrically connected to each other, and the electronic component 230, the TIM 240, and the heat dissipation member 1370 may be thermally connected to each other.

FIG. 14 is a block diagram illustrating an electronic device 1401 in a network environment 1400 according to various embodiments. Referring to FIG. 14, the electronic device 1401 in the network environment 1400 may communicate with an electronic device 1402 via a first network 1498 (e.g., a short-range wireless communication network), or at least one of an electronic device 1404 or a server 1408 via a second network 1499 (e.g., a long-range wireless communication network). According to an embodiment, the electronic device 1401 may communicate with the electronic device 1404 via the server 1408. According to an embodiment, the electronic device 1401 may include a processor 1420, a memory 1430, an input module 1450, a sound output module 1455, a display module 1460, an audio module 1470, a sensor module 1476, an interface 1477, a connecting terminal 1478, a haptic module 1479, a camera module 1480, a power management module 1488, a battery 1489, a communication module 1490, a subscriber identification module (SIM) 1496, or an antenna module 1497. In some embodiments, at least one (e.g., the connecting terminal 1478) of the components may be omitted from the electronic device 1401, or one or more other components may be added in the electronic device 1401. In some embodiments, some of the components may be implemented as single integrated circuitry. For example, some (e.g., the sensor module 1476, the camera module 1480, or the antenna module 1497) of the components may be integrated into a single component (e.g., the display module 1460).

The processor 1420 may execute, for example, software (e.g., a program 1440) to control at least one other component (e.g., a hardware or software component) of the electronic device 1401 coupled with the processor 1420, and may perform various data processing or computation. According to one embodiment, as at least part of the data processing or computation, the processor 1420 may load a command or data received from another component (e.g., the sensor module 1476 or the communication module 1490) in a volatile memory 1432, process the command or the data stored in the volatile memory 1432, and store resulting data in a non-volatile memory 1434. According to an embodiment, the processor 1420 may include a main processor 1421 (e.g., a central processing unit (CPU) or an application processor (AP)), and an auxiliary processor 1423 (e.g., a graphics processing unit (GPU), a neural processing unit (NPU), an image signal processor (ISP), a sensor hub processor, or a communication processor (CP)) that is operable independently from, or in conjunction with, the main processor 1421. When the electronic device 1401 includes the main processor 1421 and the auxiliary processor, the auxiliary processor 1423 may be adapted to consume less power than the main processor 1421, or to be specific to a specified function. The auxiliary processor 1423 may be implemented as separate from, or as part of the main processor 1421.

The auxiliary processor 1423 may control at least some of functions or states related to at least one component (e.g., the display module 1460, the sensor module 1476, or the communication module 1490) among the components of the electronic device 1401, instead of the main processor 1421 while the main processor 1421 is in an inactive (e.g., sleep) state, or together with the main processor 1421 while the main processor 1421 is in an active state (e.g., executing an application). According to an embodiment, the auxiliary processor 1423 (e.g., an image signal processor or a communication processor) may be implemented as part of another component (e.g., the camera module 1480 or the communication module 1490) functionally related to the auxiliary processor 1423. According to an embodiment, the auxiliary processor 1423 (e.g., a neural network processing device) may include a hardware structure specified for processing an artificial intelligence (AI) model. The AI model may be generated through machine learning. The learning may be performed by the electronic device 1401 performing the AI model, and may be performed through an additional server (e.g., the server 1408). A learning algorithm may include, for example, a supervised learning algorithm, an unsupervised learning algorithm, a semi-supervised learning algorithm, or a reinforcement learning algorithm, but the disclosure is not limited thereto. The AI model may include a plurality of artificial neural network (ANN) layers. The ANN may include a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-networks or the combination of the above networks, but the disclosure is not limited thereto. The AI model may additionally or alternatively include a software structure, in addition to a hardware structure.

The memory 1430 may store various data used by at least one component (e.g., the processor 1420 or the sensor module 1476) of the electronic device 1401. The various data may include, for example, software (e.g., the program 1440) and input data or output data for a command related thererto. The memory 1430 may include the volatile memory 1432 or the non-volatile memory 1434.

The program 1440 may be stored in the memory 1430 as software, and may include, for example, an operating system (OS) 1442, middleware 1444, or an application 1446.

The input module 1450 may receive a command or data to be used by other component (e.g., the processor 1420) of the electronic device 1401, from the outside (e.g., a user) of the electronic device 1401. The input module 1450 may include, for example, a microphone, a mouse, a keyboard, a key (e.g., a button), or a digital pen (e.g., a stylus pen).

The sound output module 1455 may output sound signals to the outside of the electronic device 1401. The sound output module 1455 may include, for example, a speaker or a receiver. The speaker may be used for general purposes, such as playing multimedia or playing record, and the receiver may be used for an incoming calls. According to an embodiment, the receiver may be implemented as separate from, or as part of the speaker.

The display module 1460 may visually provide information to the outside (e.g., a user) of the electronic device 1401. The display module 1460 may include, for example, a display, a hologram device, or a projector and control circuitry to control a corresponding one of the display, hologram device, and projector. According to an embodiment, the display module 1460 may include touch sensor adapted to detect a touch, or a pressure sensor adapted to measure the intensity of force incurred by the touch.

The audio module 1470 may convert a sound into an electrical signal and vice versa. According to an embodiment, the audio module 1470 may obtain the sound via the input module 1450, or output the sound via the sound output module 1455 or an external electronic device (e.g., the electronic device 1402) (e.g., speaker of headphone) directly (e.g., wiredly) or wirelessly coupled with the electronic device 1401.

The sensor module 1476 may detect an operational state (e.g., power or temperature) of the electronic device 1401 or an environmental state (e.g., a state of a user) external to the electronic device 1401, and then generate an electrical signal or data value corresponding to the detected state. According to an embodiment, the sensor module 1476 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1477 may support one or more specified protocols to be used for the electronic device 1401 to be coupled with the external electronic device (e.g., the electronic device 1402) directly (e.g., wiredly) or wirelessly. According to an embodiment, the interface 1477 may include, for example, a high definition multimedia interface (HDMI), a universal serial bus (USB) interface, a secure digital (SD) card interface, or an audio interface.

A connecting terminal 1478 may include a connector via which the electronic device 1401 may be physically connected with the external electronic device (e.g., the electronic device 1402). According to an embodiment, the connecting terminal 1478 may include, for example, a HDMI connector, a USB connector, a SD card connector, or an audio connector (e.g., a headphone connector).

The haptic module 1479 may convert an electrical signal into a mechanical stimulus (e.g., a vibration or a movement) or electrical stimulus which may be recognized by a user via his tactile sensation or kinesthetic sensation. According to an embodiment, the haptic module 1479 may include, for example, a motor, a piezoelectric element, or an electric stimulator.

The camera module 1480 may capture a still image or moving images. According to an embodiment, the camera module 1480 may include one or more lenses, image sensors, image signal processors, or flashes.

The power management module 1488 may manage power supplied to the electronic device 1401. According to one embodiment, the power management module 1488 may be implemented as at least part of, for example, a power management integrated circuit (PMIC).

The battery 1489 may supply power to at least one component of the electronic device 1401. According to an embodiment, the battery 1489 may include, for example, a primary cell which is not rechargeable, a secondary cell which is rechargeable, or a fuel cell.

The communication module 1490 may support establishing a direct (e.g., wired) communication channel or a wireless communication channel between the electronic device 1401 and the external electronic device (e.g., the electronic device 1402, the electronic device 1404, or the server 1408) and performing communication via the established communication channel. The communication module 1490 may include one or more communication processors that are operable independently from the processor 1420 (e.g., the application processor (AP)) and supports a direct (e.g., wired) communication or a wireless communication. According to an embodiment, the communication module 1490 may include a wireless communication module 1492 (e.g., a cellular communication module, a short-range wireless communication module, or a global navigation satellite system (GNSS) communication module) or a wired communication module 1494 (e.g., a local area network (LAN) communication module or a power line communication (PLC) module). The corresponding communication module among the above-described communication modules may communicate with the external electronic device 1404 via the first network 1498 (e.g., a short-range communication network, such as Bluetooth^{™}, wireless-fidelity (Wi-Fi) direct, or infrared data association (IrDA)) or the second network 1499 (e.g., a long-range communication network, such as a legacy cellular network, 5G network, next generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1492 may identify or authenticate the electronic device 1401 in a communication network, such as the first network 1498 or the second network 1499, using subscriber information (e.g., international mobile subscriber identity (IMSI)) stored in the subscriber identification module 1496.

The wireless communication module 1492 may support a 5G network and a next-generation communication technology, for example, a new radio (NR) access technology after a 4G network. The NR access technology may support high-speed transmission for high capacity data (enhanced mobile broadband; eMBB), terminal power minimizing and multiple terminal access (massive machine type communication; mMTC), or ultra-reliable and low-latency communications (URLLC). The wireless communication module 1492 may support a high-frequency band (e.g., mmWave band) to achieve, for example, a higher data rate. The wireless communication module 1492 may support various technologies, for example, beamforming, massive multiple-input and multiple-output (MIMO), Full-dimensional MIMO, an array antenna, analog beam-forming, or a large-scale antenna, to secure performance in high frequency bands. The wireless communication module 1492 may support various requirements defined in the electronic device 1401, the external electronic device (e.g., the electronic device 1404) or the network system (e.g., the second network 1499). According to one embodiment, the wireless communication module 1492 may support a peak data rate (e.g., 20Gbps or more) for eMBB realization, loss coverage (e.g., 164 dB or less) for mMTC realization, or U-plane latency (e.g., 0.5 ms or less, or the round trip of 1 ms or less in each of a downlink (DL) and an uplink (UL)) for URLCC realization.

The antenna module 1497 may transmit or receive a signal or power to or from the outside (e.g., the external electronic device) of the electronic device 1401. According to an embodiment, the antenna module 1497 may include an antenna including a radiating element composed of a conductive material or a conductive pattern formed in or on a substrate (e.g., PCB). According to an embodiment, the antenna module 1497 may include a plurality of antennas (e.g., an array antenna). In such a case, at least one antenna appropriate for a communication scheme used in the communication network, such as the first network 1498 or the second network 1499, may be selected, for example, by the communication module 1490 from the plurality of antennas. The signal or the power may then be transmitted or received between the communication module 1490 and the external electronic device via the selected at least one antenna. According to an embodiment, another component (e.g., a radio frequency integrated circuit (RFIC)) other than the radiating element may be additionally formed as part of the antenna module 1497.

According to various embodiments, the antenna module 1497 may form an mmWave antenna module. According to an embodiment, the mmWave antenna module may include a printed circuit board, an RFIC disposed on a first surface (e.g., a bottom surface) of the printed circuit board, or disposed adjacent to the first surface to support the specific high frequency band (e.g., mmWave band), and a plurality of antennas (e.g., an array antenna) disposed on a second surface (e.g., a top surface or a side surface) of the printed circuit board or disposed adjacent to the second surface to transmit or receive a signal having the specified high frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1401 and the external electronic device 1404 via the server 1408 coupled with the second network 1499. Each of the external electronic devices 1402 or 1404 may be a device of a same type as, or a different type, from the electronic device 1401. According to an embodiment, all or some of operations to be executed at the electronic device 1401 may be executed at one or more of the external electronic devices 1402, 1404, or 1408. For example, when the electronic device 1401 should perform a function or a service automatically, or in response to a request from a user or another device, the electronic device 1401, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1401. The electronic device 1401 may provide the outcome, with or without further processing of the outcome, as at least part of a reply to the request. To that end, a cloud computing, distributed computing, mobile edge computing (MEC), or client-server computing technology may be used, for example. The electronic device 1401 may provide an ultra-latency service by using, for example, distributed computing or mobile edge computing. According to various embodiments, the external electronic device 1404 may include the Internet of things (IoT). The server 1408 may be an artificial server using machine learning and/or a neural network. According to an embodiment, the external electronic device 1404 or the server 1408 may be included in the second network 1499. The electronic device 1401 may be applied to an artificial intelligence service (e.g., a smart home, a smart city, a smart car, or healthcare service) based on the 5G communication technology and the IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 1440) including one or more instructions that are stored in a storage medium (e.g., internal memory 1436 or external memory 1438) that is readable by a machine (e.g., the electronic device 1401). For example, a processor (e.g., the processor 1420) of the machine (e.g., the electronic device 1401) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities and some of multiple entities may be separately disposed on the other components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a printed circuit board;
a shield can disposed on the printed circuit board to define a first cavity, and having a first opening communicating the first cavity at an upper portion thereof;
an electronic component disposed on the printed circuit board, and located in the cavity;
a shielding sheet disposed at an upper portion of the shield can, communicating the first cavity through the first opening of the shield can, and defining a second cavity having an opened upper side, wherein the shielding sheet includes a first part contacting the upper portion of the shield can;
a heat dissipation member disposed on the shielding sheet to close the opened upper side of the second cavity;
a thermal interface material (TIM) disposed between the heat dissipation member and the electronic component; and
an elastic member disposed between the first part of the shielding sheet and the heat dissipation member in the second cavity to provide an elastic force to the first part,
wherein the shield can, the shielding sheet, and the heat dissipation member are connected to each other,
wherein the electronic component, the TIM, and the heat dissipation member are thermally connected to each other,
wherein the first cavity has a first width along one direction parallel to the printed circuit board,
wherein the second cavity has a second width along the one direction parallel to the printed circuit board, and
wherein the second width is greater than the first width.

2. The electronic device of claim 1, wherein the first part of the shielding sheet directly contacts the upper portion of the shield can.

3. The electronic device of claim 2, wherein the shielding sheet includes a shielding film and a conductive adhesive layer, and
wherein the conductive adhesive layer is disposed between the shielding flm and the heat dissipation member.

4. The electronic device of claim 3, wherein the shielding film includes a first part directly contacting the upper surface of the shield can, and
wherein the conductive adhesive layer includes a first part interposed between the first part and the elastic member to attach the first part of the shielding film to the elastic member.

5. The electronic device of claim 4, wherein the shielding sheet includes a second part directly contacting the heat dissipation member.

6. The electronic device of claim 5, wherein the shielding film includes:
a second part located in the shield can to be more distant than the first part with respect to a direction parallel to the printed circuit board; and
a third part connecting the first part and the second part,
wherein the conductive adhesive layer includes:
a second part disposed between the second part of the shielding film and the heat dissipation member to attach the second part of the shielding film to the heat dissipation member, and
wherein the first part and the second part of the conductive adhesive layer are spaced apart from each other.

7. The electronic device of claim 6, wherein the conductive adhesive layer includes a third part connecting the first part and the second part of the conductive adhesive layer,
wherein an area of the second part of the conductive adhesive layer is greater than an area of the first part of the shielding film.

8. The electronic device of any one of claim 1 to claim 7, further comprising:
a rear plate facing a first surface of the printed circuit board; and
a bracket facing a second surface of the printed circuit board opposite to the first surface,
wherein the heat dissipation member includes:
a vapor chamber disposed on the shielding sheet to close the second cavity, and having a conductive surface; and
a graphite sheet disposed between at least any one of the rear plate and the bracket and the vapor chamber, and
wherein the vapor chamber and the graphite sheet are adhered to each other.

9. The electronic device of any one of claim 1 to claim 7, further comprising:
a rear plate facing a first surface of the printed circuit board; and
a bracket facing a second surface of the printed circuit board opposite to the first surface,
wherein the heat dissipation member includes:
a conductive layer disposed on the shielding sheet to close the opened upper side of the second cavity; and
a graphite sheet disposed between at least any one of the rear plate and the bracket and the conductive layer.

10. The electronic device of any one of claim 1 to claim 7, further comprising:
a rear plate facing a first surface of the printed circuit board; and
a bracket facing a second surface of the printed circuit board opposite to the first surface,
wherein the heat dissipation member includes:
a conductive block disposed between the TIM and at least any one of the rear plate and the bracket.

11. The electronic device of any one of claim 1 to claim 7, further comprising:
a rear plate facing a first surface of the printed circuit board; and
a bracket facing a second surface of the printed circuit board opposite to the first surface,
wherein the heat dissipation member includes:
a rear plate defining a rear surface of the electronic device; and
a vapor chamber welded to at least any one of the rear plate and the bracket and disposed at an upper portion of the shielding sheet to close the opened upper side of the second cavity.

12. The electronic device of any one of claim 1 to claim 7, further comprising:
a rear plate facing a first surface of the printed circuit board; and
a bracket facing a second surface of the printed circuit board opposite to the first surface,
wherein the heat dissipation member includes:
a rear plate defining a rear surface of the electronic device;
a graphite sheet attached to at least any one of the rear plate and the bracket and having a first groove defined on a first surface facing the electronic component; and
a conductive layer formed on the first surface of the graphite sheet and having a second groove formed in one surface facing the electronic component to correspond to a position of the first groove, and
wherein the TIM is accommodated in the second groove.

13. The electronic device of any one of claim 1 to claim 7, further comprising:
a rear plate facing a first surface of the printed circuit board; and
a bracket facing a second surface of the printed circuit board opposite to the first surface,
wherein the heat dissipation member includes:
a rear plate defining a rear surface of the electronic device and disposed on the shielding sheet to close the opened upper side of the second cavity,
wherein at least any one of the rear plate and the bracket includes a recess formed on a first surface facing the electronic component, and
wherein the TIM is seated in the recess.

14. The electronic device of any one of claim 1 to claim 7, wherein the elastic member is soldered to the heat dissipation member.

15. The electronic device of any one of claim 1 to claim 7, further comprising:
a bracket including a third opening overlapping the electronic component;
a heat dissipation sheet disposed on the bracket to close the third opening; and
a display disposed on the heat dissipation sheet,
wherein the printed circuit board includes a first surface and a second surface facing an opposite direction to the first surface,
wherein the electronic component and the shield can are disposed on at least any one of the first surface and the second surface of the printed circuit board, and
wherein the bracket is disposed on the second surface of the printed circuit board.
